(19) Europäisches Patentamt
European Patent Office
Office européen des brevets

(11) EP 1 759 035 B1

(12) # EUROPEAN PATENT SPECIFICATION

(45) Date of publication and mention of the grant of the patent:
**17.08.2011 Bulletin 2011/33**

(21) Application number: **05756637.4**

(22) Date of filing: **03.06.2005**

(51) Int Cl.:
*C23C 14/24* (2006.01) *C23C 14/26* (2006.01)
*H01L 51/40* (2006.01)

(86) International application number:
**PCT/US2005/019648**

(87) International publication number:
**WO 2006/007280 (19.01.2006 Gazette 2006/03)**

(54) **VAPORIZING TEMPERATURE SENSITIVE MATERIALS**

VERDAMPFUNG VON TEMPERATUREMPFINDLICHEN SUBSTANZEN

MATÉRIAUX SENSIBLES À LA TEMPÉRATURE DE VAPORISATION

(84) Designated Contracting States:
**DE GB**

(30) Priority: **17.06.2004 US 870623**

(43) Date of publication of application:
**07.03.2007 Bulletin 2007/10**

(73) Proprietor: **Global OLED Technology LLC**
**Wilmington, Delaware 19801 (US)**

(72) Inventors:
- **GRACE, Jeremy Matthew**
  **Penfield, New York 14526 (US)**
- **LONG, Michael**
  **Hilton, New York 14468 (US)**
- **KOPPE, Bruce Edward**
  **Calendonia, New York 14423 (US)**

(74) Representative: **Wibbelmann, Jobst et al**
**Wuesthoff & Wuesthoff**
**Patent- und Rechtsanwälte**
**Schweigerstrasse 2**
**81541 München (DE)**

(56) References cited:
**EP-A- 1 176 647** **US-A- 5 266 117**
**US-A- 5 474 809**

- **PATENT ABSTRACTS OF JAPAN vol. 008, no. 222 (C-246), 9 October 1984 (1984-10-09) & JP 59 104472 A (NIPPON DENSHIN DENWA KOSHA), 16 June 1984 (1984-06-16)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 759 035 B1

## Description

### FIELD OF THE INVENTION

The present invention relates to the field of physical vapor deposition where a source material is heated to a temperature so as to cause vaporization and produce a vapor plume to form a thin film on a surface of a substrate.

### BACKGROUND OF THE INVENTION

An OLED device includes a substrate, an anode, a hole-transporting layer made of an organic compound, an organic luminescent layer with suitable dopants, an organic electron-transporting layer, and a cathode. OLED devices are attractive because of their low driving voltage, high luminance, wide-angle viewing and capability for full-color flat emission displays. Tang et al. described this multilayer OLED device in their U.S. Patents 4,769,292 and 4,885,211.

Physical vapor deposition in a vacuum environment is the principal way of depositing thin organic material films as used in small molecule OLED devices. Such methods are well known, for example, in Barr U.S. Patent 2,447,789 and Tanabe et al. EP 0 982 411. The organic materials used in the making of OLED devices are often subject to degradation when maintained at or near the desired rate-dependent vaporization temperature for extended periods of time. Exposure of sensitive organic materials to higher temperatures can cause changes in the structure of the molecules and associated changes in material properties.

To overcome the thermal sensitivity of these materials, only small quantities of organic materials have been loaded in sources, and they are heated as little as possible. In this manner, the material is consumed before it has reached the temperature exposure threshold to cause significant degradation. The limitations with this practice are that the available vaporization rate is very low due to the limitation on heater temperature, and the operation time of the source is very short due to the small quantity of material present in the source. The low deposition rate and frequent source recharging place substantial limitations on the throughput of OLED manufacturing facilities.

A secondary consequence of heating the entire organic material charge to roughly the same temperature is that it is impractical to mix additional organic materials, such as dopants, with a host material unless the vaporization behavior and vapor pressure of the dopant is very close to that of the host material. This is generally not the case and, as a result, prior art devices frequently require the use of separate sources to codeposit host and dopant materials.

Obtaining the desired film composition from a mixture of materials by thermal evaporation has also been discussed in the prior art pertaining to semiconductor devices. U.S. Patent 3,607,135 to Gereth et al. disclose flash evaporation in combination with a guide funnel and tube feed mechanism to solve the problem of maintaining film composition from a mixture of As and Ga, which have significantly disparate vapor pressure curves. Continuous operation is achieved by advancing powder through a tube by use of a threaded piston arrangement. The tube delivers powder to a vibrating trough, which feeds material to the guide funnel and into the flash evaporation zone. Care is taken to control relative temperatures of the flash evaporation zone and the surfaces of the guide funnel and feed tube assembly so as to avoid occlusion of the feed mechanism during the course of operation. U.S. Patent 3,990,894 to Kinoshita et al. discloses the use of several thermal deposition sources in succession having differing material compositions to compensate for the drift in composition resulting from the disparate vapor pressure curves of Se and Te in making a thin film of a specific Se-Te alloy. Japanese Publication 06-161137 to Naoyuki et al. discloses the use of a conveyor belt feed mechanism and flash evaporation to deposit pure Se and alloys of Se/Te and Se/As. In their disclosure, the material delivered by conveyor belt is a coarse particulate with particle sizes in the range of 1-2 mm.

Other disclosed uses of flash evaporation techniques include deposition of oxide buffer layers, metal thin film resistors, generation of superfine particles, deposition of polymer layers and multilayers, and mixtures of OLED materials to form a white emitting device. U.S. Patent 5,453,306 to Tatsumi et al. discloses the use of carrier gas to deliver powder to a plasma torch for depositing oxide buffer layers. U.S. Patent 4,226,899 to Thiel et al. discloses the use of continuous wire feed in combination with flash evaporation to deposit thin film resistors having the desired temperature coefficient of resistance. U.S. Patent 6,040,017 to Mikhael et al. discloses flash evaporation of atomized polymer liquids to produce polymer multilayers. U.S. Patent 6,268,695 to Affinito mentions flash evaporation as a possible technique in depositing polymer-oxide multilayers for barrier materials for OLED devices. Japanese Publication 09-219289 to Kenji et al. discloses the use of flash evaporation to deposit white emitting OLED devices from mixed powder components. While some of these disclosures discuss the use of powders, none teaches a method for delivering a powder or weakly cohesive solid at constant rate to the flash evaporation source and none discusses a suitable way to compensate for nonuniform delivery rate in a powder feed mechanism.

For deposition on stationary substrates, a limiting factor for control of coating thickness is the degree of constancy of the material feed rate. Even if thickness monitoring techniques are used, if the deposition rate is not suitably stable, it can be difficult to achieve the desired end point thickness. Techniques based on vibration, such as that disclosed in U.S. Patent 3,607,135, have a fair probability of suffering nonuniformity of feed rate from agglomeration of material in

the feed path, which can either cause blockage and loss of rate or can cause uneven vapor delivery rate, as particles of highly varying size enter the flash evaporation zone in uncontrolled manner. Similarly, a technique in which powders drop from conveyor belts (Japanese Publication 06-161137) has a fair probability of suffering nonuniformity of feed rate for small particles, which can tend to adhere to the conveyor belt to some uncontrolled degree and thus cause variation in the rate at which material drops into the flash evaporation zone.

As with other powder feed-based techniques, control of composition can be accomplished by mixing the materials to be deposited prior to introducing them to the feed mechanism. Alternatively, because the approach of commonly assigned U.S. Patent Application Serial No. 10/784,585 filed February 23, 2004 by Michael Long et al., entitled "Device and Method for Vaporizing Temperature Sensitive Materials", the disclosure of which is herein incorporated by reference, lends itself to small areas for the flash evaporation zone, multiple single-component sources can be arranged to vaporize material into a heated manifold. Control of their relative rates (through material feed rate and heater temperature) permits one to control the composition of the deposited film over a broad range. While commonly assigned U.S. Patent Application Serial No. 10/784,585 discloses a superior method for delivering material at uniform rate in controllable fashion, for precise control of delivery rate, the challenge still remains that a column of powder or a weakly bound solid must be delivered to a flash evaporation zone with extremely uniform material feed rate.

Coating large-area substrates (i.e., in excess of 20 cm x 20 cm) presents the additional challenge of maintaining a constant substrate velocity over the deposition zone. The combination of requiring constant substrate velocity and constant material feed rate present significant engineering challenges for large-area coatings by flash evaporation. In addition, multiple component films must be deposited with equally effective control of material feed rates of all components in order to obtain repeatable compositions or constant composition throughout the film.

## SUMMARY OF THE INVENTION

It is therefore an object of the present invention to provide a way whereby highly uniform thickness coatings can be obtained.

It is a further object of the present invention to provide a way to deposit one or more materials from the same source with extremely precise control over the relative amounts of each material in the deposited coating.

These objects are achieved by a method for vaporizing organic material onto a substrate surface deposit an organic film of controlled thickness and uniformity, comprising:

a) providing a quantity of organic material into a vaporization apparatus that defines a deposition zone;
b) actively maintaining the organic material in the vaporization apparatus at a base temperature $T_b$;
c) applying a heat pulse to a portion of the organic material by providing a current pulse to a heater to raise the temperature of such material portion to a temperature $T_v$ which is greater than $T_b$, thereby causing such material portion to vaporize as a vapor pulse and be applied onto a predetermined portion of the substrate surface that is exposed to the vaporized material in the deposition zone;
d) providing stepwise motion to the substrate, wherein the motion is a predetermined fraction of the deposition zone, thereby changing the position of the substrate surface relative to the deposition zone; and
e) repeating steps c) and d) one or more times until the substrate has passed from one end of the deposition zone to the other to deposit an organic film of controlled thickness and uniformity on the substrate surface.

## ADVANTAGES

It is an advantage of the present invention that it overcomes the need to have extremely uniform and constant material feed rate and substrate motion during deposition. In addition, the present invention overcomes heating and volume limitations of prior art devices in that only a small portion of material is heated to the desired rate-dependent vaporization temperature at a controlled rate. It is therefore a feature of the present invention to maintain a steady state time-varying vaporization process with a large charge of material, with pulsed heater temperature in synchronization with stepwise motion of the substrate. The present invention thus permits extended operation of the source with substantially reduced risk of degrading even very temperature sensitive materials. This feature additionally permits materials having different vaporization rates and degradation temperature thresholds to be co-sublimated in the same source.

It is another advantage of the present invention that it permits finer rate control through pulse height (also referred to as pulse amplitude) or pulse width modulation of the heater current. The same fine control via the heat pulse shape can be used to precisely meter dopant materials in combination with host materials by situating them in the same delivery manifold and pulsing them separately to control the relative amounts delivered to the substrate.

It is still another advantage of the present invention that it can be cooled and reheated in a matter of seconds to stop and reinitiate vaporization and achieve a steady vaporization rate quickly. This feature reduces contamination of the deposition chamber walls and conserves the materials when a substrate is not being coated.

It is a further advantage that the present device achieves substantially higher vaporization rates than in prior art devices without material degradation.

It is a still further advantage of the present invention that it can provide a vapor source in any orientation, which is not possible with prior art devices.

## BRIEF DESCRIPTION OF THE DRAWINGS

FIG. 1 is a cross-sectional schematic representation of a flash evaporation source indicating the various parameters used to model the source response to a flash evaporation pulse;

FIG. 2 shows an example of modeled evaporant (i.e., material to be deposited) surface temperature and manifold pressure in the source of FIG. 1 as a function of time in response to heat pulses;

FIG. 3 shows the required off time $t_{off}$ for complete decay of vapor pressure pulses as a function of cooling time constant $\tau_c$ modeled for the source of FIG. 1;

FIG. 4A and FIG. 4B show representative modeled evaporant (i.e., material to be deposited) surface temperature $T_v$ and manifold pressure as a function of time in response to heat pulses, for cooling time constant values of 1 s and 20 s, respectively. The modeled responses are from the set used to provide the data shown in FIG. 3;

FIG. 5 shows the required heat input $T_{max}$ as a function of heating time constant $\tau_H$ such that the average pressure and hence rate is maintained for the source of FIG. 1.;

FIG. 6A and FIG. 6B show representative modeled evaporant surface temperature $T_v$ and manifold pressure as a function of time in response to heat pulses, for heating time constant values of 0.1 s and 10 s, respectively. The modeled responses are from the set used to provide the data shown in FIG. 5;

FIG. 7 shows the required heat input $T_{max}$ as a function of the base temperature $T_b$ while maintaining average pressure and hence rate for the source of FIG. 1;

FIG. 8A and FIG. 8B show representative modeled evaporant surface temperature $T_v$ and manifold pressure as a function of time in response to heat pulses, for base temperature $T_b$ values of 273 K and 423 K, respectively. The modeled responses are from the set used to provide the data shown in FIG. 7;

FIG. 9 shows the average pressure (and hence relative rate) as a function of the pulse duration $t_{pulse}$, modeled for the source of FIG. 1 and illustrates manipulation of deposition rate by pulse width control;

FIG. 10A and FIG. 10B show representative modeled evaporant surface temperature $T_v$ and manifold pressure as a function of time in response to heat pulses, for pulses duration $t_{pulse}$ values of 1 s and 4 s, respectively. The modeled responses are from the set used to provide the data shown in FIG. 9;

FIG. 11 shows the average pressure (and hence relative rate) as a function of pulse heat input $T_{max}$ modeled for the source of FIG. 1 and illustrates manipulation of deposition rate by pulse height (or pulse amplitude) control;

FIG. 12A and FIG. 12B show representative modeled evaporant surface temperature $T_v$ and manifold pressure as a function of time in response to heat pulses, for pulse heat inputs $T_{max}$ values of 755 K and 890 K, respectively. The modeled responses are from the set used to provide the data shown in FIG. 11;

FIG. 13A, FIG. 13B, and FIG. 13C show representative modeled evaporant surface temperature $T_v$ and manifold pressure as a function of time in response to heat pulses, for evaporant surface area $A_s$ = 1 $cm^2$ and $\tau_v$ = 80 s; As = 0.01 $cm^2$ and $\tau_v$ = 0.3 s; and $A_s$ = 0.01 $cm^2$ and $\tau_v$ = 8 s, respectively;

FIG. 14 shows the required time between pulses $t_{off}$ for complete decay of the pressure pulse as a function of the vapor time constant $\tau_v$ and an evaporant surface area $A_s$ of 0.01 $cm^2$ modeled for the source of FIG. 1;

FIG. 15A and FIG. 15B show schematic arrangements of sources to produce a uniform coating along the length of a substrate (schematic cross sectional view) and over a large substrate area (schematic top view), respectively;

FIG. 16 shows an array of elongated manifolds arranged to produce a uniform coating over a large substrate area;

FIG. 17A, FIG. 17B, and FIG. 17C show pulse height (pulse amplitude) controlled relative rates of host and dopant, pulse width control of relative rates of host and dopant, and alternate layers of two components, respectively;

FIG. 18 shows a schematic of a flash evaporation deposition system with synchronized heat pulses, substrate motion, and material feed;

FIG. 19 shows the representative geometry used to calculate the deposition uniformity for substrates moved stepwise through a coating zone;

FIG. 20 shows modeled thickness profiles for 1, 2, and 6 steps using the geometry shown in FIG. 19;

FIG. 21 shows the modeled nonuniformity as a function of number of steps for a line source and different source-substrate spacings and plume shape exponents for the geometry depicted in FIG. 19;

FIG. 22 shows the modeled nonuniformity as a function of number of steps for a point source and different source-substrate spacings and plume shape exponents for the geometry depicted in FIG. 19;

FIG. 23 shows a side cross section schematic of a flash evaporation source to produce vapor pulses by heat pulse

control or heat pulse control in combination with material feed control; and
FIG. 24 is a side cross section of a layer structure used in making OLED devices.

## DETAILED DESCRIPTION OF THE INVENTION

In order to illustrate the benefits of the present invention two models were constructed. The first model calculates the time-dependent pressure inside a vaporization manifold in response to heat pulses applied to an evaporant (i.e., material to be deposited by vaporization). The second model calculates the coating uniformity along the direction of motion of a substrate moved in stepwise fashion across a deposition zone containing a source that emits a vapor plume of specified shape.

The source geometry and model parameters are shown in FIG. 1. The deposition source 1 comprises a heated manifold 2 having an exit surface 3 with an aperture 4 or plurality of apertures 4 having total conductance $C_A$. The evaporant 5 (i.e., material to be deposited, sublimate, material to be vaporized or sublimed) is located in a vaporization region 6 and is placed in contact with a heating element 7 on one surface, and is in contact with a region of lower temperature 8 on most of its remaining surface. The bulk of the evaporant is maintained at the lower temperature $T_b$, while the heating element 7 is used to bring the temperature of the contacted surface to a vaporization temperature $T_v$.

The time required to establish $T_v$ depends on the heat input and the thermal contact of the material to the region held at $T_b$. Accordingly there are time constants of heating and cooling $\tau_H$ and $\tau_C$ associated with the time dependence of $T_v$. The input power to the heating element 7 is expressed as a temperature $T_{max}$, which would be the steady state temperature of the evaporant surface in the absence of cooling other than by diffusion of heat from the evaporant surface through the evaporant and to the region of lower temperature. Using Newton's law of cooling, the rate of change of the evaporant surface temperature $T_v$ is given by:

$$\frac{dT_v}{dt} = \frac{(T_{maz} - T_v)}{\tau_H} - \frac{(T_v - T_b)}{\tau_C} \qquad (1).$$

The vaporization rate obtained by establishing the temperature $T_v$ at the evaporant surface having area $A_v$ is given by:

$$dP = \frac{A_v}{V_m} P_v \sqrt{\frac{kT_v}{2\pi M}} dt\,, \qquad (2)$$

where $V_m$ is the volume of the manifold **2**, k is the Boltzmann constant, M is the molecular mass of the evaporant material, and $P_v$ is the vapor pressure of the material. Because vaporization is a thermally activated process, the vapor pressure $P_v$ often has the form:

$$P_v = e^{\left(a - \frac{b}{T_v}\right)} \qquad (3).$$

In addition to pressurization of the manifold by vaporization, there is loss of pressure to the area $A_s$ driven by the actual pressure P within the manifold, as well as loss of pressure through the aperture(s) having a total conductance $C_A$. Thus, the net pressurization rate in the manifold is given by:

$$dP = \left[\frac{A_s}{V_m}(P_v - P)\sqrt{\frac{kT_v}{2\pi M}} - \frac{C_A P}{V_m}\right] dt \qquad (4).$$

It is assumed the pressure outside the manifold is negligible (vacuum) and that the manifold walls are sufficiently hot so that no significant condensation occurs on them. The vapor time constant $\tau_v = V_m/C_A$ can be used to express the aperture loss term in the above equation, as $dP=-(P/\tau_v.)dt$.

A heat pulse **9** applied to the heating element **7** has a pulse width $t_{pulse}$, a pulse height $T_{max}$, and time between pulses $t_{off}$. When the pulse is on, the term $T_{max}$-$T_v$ in Eq.1 applies. When the pulse is off, the heating term is set to zero and only the cooling term $T_v$-$T_b$ remains.

Starting with the initial condition P=0 and $T_v$=$T_b$, the progression of $T_v$ and P can be computed by calculating $dT_v$ (Eq. 1) and dP (Eq. 4 using $P_v$ from Eq. 3) for a given time step dt. The values of $T_v$ and P are then updated by adding respectively $dT_v$ and dP, and another time step is taken. The process is iterated until the desired number of time steps has been completed. In the computation of $dT_v$ the heat pulse shape is taken into account by dropping the heating term when the pulse is off and applying it when the heat pulse is on.

The end result is an array of values for P(t) and for $T_v$(t). An example of calculated P(t) and $T_v$(t) values is shown in FIG. 2 for aluminum tris-quinolate ($Alq_3$). In the calculations, the parameters were set to the following values: $T_b$= 473.16 K, $T_{max}$ = 835 K, $t_{pulse}$ = 2 s, $t_{off}$= 2 s, $\tau_H$ =1 1 s, $\tau_C$ = 1 s, V= 0.04 cm x 0.04 cm x 60 cm = 9.6x$10^{-4}$ $m^3$, $C_A$ = 60 x 0.021/s = 1.2 x $10^{-3}$ $m^3$/s, $A_s$ = 1cm x 1 cm = 1 x $10^{-4}$ $m^2$. (For the values for V and $C_A$, $\tau_V$ = 0.8 s). The time step size was set to 5 x $10^{-3}$ s. As an approximation to the vapor pressure curve for $Alq_3$ the values a = 24.706 ln(Torr) and b = 16743 K were used in Eq. 3. These parameters were obtained from a fit to vapor pressure measurements of $Alq_3$ using a Knudsen cell technique.

The time constants $\tau_C$, $\tau_H$, and $\tau_v$ can be expected to determine the minimum time between pulses and hence the rate at which a deposition process can proceed. Applying the model of P(t) described above, one finds that a large value (i.e. slow response time) for $\tau_H$ can be overcome by using larger heat input (i.e. applying a higher value for $T_{max}$), without limiting the response time of $T_v$ and thus P. Furthermore, one finds that $\tau_v$ becomes important only in the limit of very small surface area of evaporant exposed to $T_v$. In addition, one finds that the effect of $\tau_C$ is substantially reduced because of the exponential dependence of $P_v$ on $T_v$. Whereas a typical exponential decay requires a time of 5τ to reach practical completion, the decay of the effects of a pressure pulse $P_v$ reach practical completion in less than or on the order of $\tau_C$, owing to the rapid decrease in $P_v$ with $T_v$.

In order to illustrate these effects the model for P(t) was run with a "standard" set of parameters as a point of reference. Various parameters of primary interest were then changed, and the effects on the average manifold pressure P were assessed, or values of $t_{pulse}$, $t_{off}$, and or $T_{max}$ were adjusted to give the same average pressure in the manifold with acceptable separation of pulses, and the required adjustments of these parameters were examined as a function of the parameter of primary interest.

FIG. 3 illustrates the effects of $\tau_c$ on required delay time between pulses ($t_{off}$) to obtain similar manifold response. The data in FIG. 3 were computed with the following settings: $T_b$= 373.16 K, $\tau_H$ = 1 s, V= 0.04 cm x 0.04 cm x 60 cm = 9.6x$10^{-4}$ $m^3$, $C_A$ = 60 x 0.021/s = 1.2 x $10^{-3}$ $m^3$/s, $A_s$ = 1cm x 1 cm = 1 x $10^{-4}$ $m^2$. (For the values for V and $C_A$, $\tau_v$ = 0.8 s). The time step size varied between 0.008 and 0.0175 s, depending on the choice of $\tau_c$, such that a similar number of vapor pulses was obtained. $T_{max}$, $t_{pulse}$ and $t_{off}$ were adjusted to give similar time-averaged pressure and similar ratios of peak pressure to minimum pressure before the next pulse. The target average pressure was roughly 0.076 Torr, which corresponds to a deposition rate of roughly 50 A/s at a distance of 10 cm directly over the center of a source having the aperture conductance $C_A$ indicated above. This estimate of rate is based on calculations described in commonly assigned U.S. Patent Application Serial No. 10/352,558 filed January 28, 2003 by Jeremy M. Grace et al., entitled "Method of Designing a Thermal Physical Vapor Deposition System", the disclosure of which is herein incorporated by reference. As $\tau_c$ increases, the longer temperature decay requires inclusion of shorter heat pulse (smaller $t_{putse}$) and a longer time between pulses ($t_{off}$) to produce the same pressure pulse magnitude. In addition, the number of pulses required before obtaining the steady state pulse shape increases, as it takes several pulses for the lower temperature in the temperature pulse to reach its steady state limit.

As can be seen from the FIG. 3, $t_{off}$ increases roughly linearly with $\tau_c$. The longer the time to cool the surface of the evaporant down, the more time required for the pressure pulse to completely decay. Because the surface $A_s$ acts as a sink for condensing vapor, and because the vaporization rate depends exponentially on temperature, the decay time for the vapor pulse is less than $\tau_c$, rather than of the order of 5 $\tau_c$, as would be expected if the pressure pulse followed the temperature pulse in linear fashion. In the limit of low values for $\tau_c$, $\tau_V$ can become the limiting factor in the pressure decay between pulses. Furthermore, a very low $\tau_c$ signifies excellent thermal contact between the material in the vaporization region and the region maintained at $T_b$. In such cases the required heat to produce vaporization increases substantially. Calculated pressure and temperature responses are shown in FIGS. 4A and 4B respectively for $\tau_c$ = 1 s and $\tau_c$ = 20 s.

FIG. 5 illustrates the effects of $\tau_H$. The data in FIG. 5 were computed with the following settings: $T_b$= 373 K, $\tau_C$ = 3 s, $t_{pulse}$= 1 s, $t_{off}$= 3 s, V = 0.04 cm x 0.04 cm x 60 cm = 9.6x$10^{-4}$ $m^3$, $C_A$ = 60 x 0.021/s = 1.2 x $10^{-3}$$m^3$/s, $A_s$ = 1 cm x 1 cm = 1 x $10^{-4}$ $m^2$. (For the values for V and $C_A$, $\tau_V$ = 0.8 s). The time step size was 0.005 s. $T_{max}$, was adjusted to give similar time-averaged pressure and similar ratios of peak pressure to minimum pressure before the next pulse. As described in the discussion of FIG. 3, the target average pressure was roughly 0.076 Torr, and the same vapor pressure parameters were used for $Alq_3$. As can be seen from FIG. 5, the larger the value for $\tau_H$, the larger the $T_{max}$ to obtain the same average manifold pressure (which is directly related to the pressure pulse magnitude). Even though the $T_{max}$

values are increasing with $\tau_H$, the actual peak values for $T_v$ are the same (roughly 650 K), and the required time between pulses $t_{off}$ does not change. The significance of the $T_{max}$ value is that more power input is required in order to make the temperature rise sufficiently rapidly that $T_v$ rises to the required value within the duration of the chosen $t_{pulse}$. Calculated pressure and temperature responses are shown in FIGS. 6A and 6B respectively for $\tau_H$ = 0.1 s and $\tau_H$ = 10 s.

The effect of $T_b$ is illustrated in FIG. 7. The data in FIG. 7 were computed with the following settings: $\tau_H$ = 1 s, $\tau_C$ = 3 s, $t_{pulse}$= 1 s, $t_{off}$ = 3 s, V = 0.04 cm x 0.04 cm x 60 cm = 9.6x10$^{-4}$ m$^3$, $C_A$ = 60 x 0.021/s = 1.2 x 10$^{-3}$ m$^3$/s, $A_s$ = 1 cm x 1 cm = 1 x 10$^{-4}$ m$^2$. For the values for V and $C_A$, $\tau_V$ = 0.8 s). The time step size was 0.005 s. $T_{max}$, was adjusted to give similar time-averaged pressure and similar ratios of peak pressure to minimum pressure before the next pulse. As described in the discussion of FIG. 3, the target average pressure was roughly 0.076 Torr, and the same vapor pressure parameters were used for $Alq_3$. As can be seen from FIG. 7, as $T_b$ increases, $T_{max}$ decreases in order to obtain the same average manifold pressure (and hence pressure pulse magnitude). As the $T_{max}$ values change with $T_b$, the actual peak values for $T_v$ also change, but not as dramatically as does $T_{max}$. In addition, the pressure pulse shape broadens as $T_b$ is increases. If $T_b$ is raised too much, the vapor pulse never completely decays, as $T_b$ can be high enough to produce significant vaporization and thus contribute to the manifold pressure with no additional heat supplied through the pulsed heating element. When the vapor pressure caused by $T_b$ becomes a significant fraction of the peak pressure (i.e. above 0.1 %) then the pressure pulse is never "off'. For applications where no significant deposition can occur between pulses, $T_b$ must be kept below a certain maximum value. For applications where the rate is modulated above a base value, $T_b$ can be set to achieve the base value, and the heat pulse parameters can be selected to achieve the appropriate modulation above the base value. Calculated pressure and temperature responses are shown in FIGS. 8A and 8B respectively for $T_b$ = 273 K and $T_b$ = 423 K.

FIG. 9 illustrates the use of $t_{pulse}$ to vary the average manifold pressure (or pressure pulse magnitude). The data in FIGS. 6A and 6B were computed with the following settings: $T_b$= 373.16 K, $T_{max}$= 755 K, $t_{off}$= 4 s, $\tau_H$= 1 s, $\tau_C$ = 3 s, $t_{off}$= 3 s,V = 0.04 cm x 0.04 cm x 60 cm = 9.6x10$^{-4}$ m$^3$, $C_A$ = 60 x 0.021/s =1.2 x 10$^{-3}$ m$^3$/s, As =1 cm x 1 cm =1 x 10$^{-4}$ m$^2$. For the values for V and $C_A$, $\tau_V$ = 0.8 s). The time step size was 0.005 s. The same vapor pressure parameters were used for $Alq_3$ as described above. $t_{pulse}$, was varied to illustrate its effect on the average manifold pressure. Consequently, the pressure pulse width increased with $t_{pulse}$. Over the range of values used for $t_{pulse}$, the pressure decay between pulses during $t_{off}$ was not significantly affected by changing $t_{pulse}$. As can be seen from FIG. 9, the average manifold pressure (and pressure pulse magnitude) and hence the deposition rate (or material deposited per pulse) can be varied substantially by changing $t_{putse}$. Thus, FIG. 9 illustrates pulse width modulation of the vapor emitted from the source. Calculated pressure and temperature responses are shown in FIGS. 10A and 10B respectively for $t_{pulse}$ = 1 s and $t_{pulse}$= 4 s.

FIG. 11 illustrates the use of $T_{max}$ to vary the average manifold pressure (or pressure pulse magnitude). The data in FIG. 11 were computed with the following settings: $T_b$= 373.16 K, $t_{pulse}$ =1 s, $t_{off}$= 2 s, $\tau_H$ =1 s, $\tau_C$ = 3 s, V = 0.04 cm x 0.04 cm x 60 cm = 9.6x10$^{-4}$ m$^3$, $C_A$ = 60 x 0.021/s = 1.2 x 10$^{-3}$ m$^3$/s, As =1 cm x 1 cm = 1 x 10$^{-4}$ m$^2$. (For the values for V and $C_A$, $\tau_V$ = 0.8 s). The time step size was 0.005 s. The same vapor pressure parameters were used for $Alq_3$ as described above. $T_{max}$ was varied to illustrate its effect on the average manifold pressure. Consequently, the pressure pulse height increased with $t_{pulse}$. Over the range of values used for $T_{max}$, the pressure decay between pulses during $t_{off}$ was not significantly affected by changing $t_{pulse}$. As can be seen from FIG. 11, the average manifold pressure (and pressure pulse magnitude) and hence the deposition rate (or material deposited per pulse) can be varied substantially by changing $T_{max}$. Thus, FIG. 11 illustrates pulse height (or pulse amplitude) modulation of the vapor emitted from the source. Calculated pressure and temperature responses are shown in FIGS. 12A and 12B respectively for $T_{max}$ = 755 K and $t_{max}$ = 890 K.

FIGS. 13A-C and 14 illustrates the effect of evaporant surface area and $\tau_v$. The calculate pressure and temperature responses in FIG. 13A were computed with the following settings: $T_b$= 373.16 K, $t_{pulse}$ =1 s, $t_{off}$ = 4 s, $\tau_H$ =1 s, $\tau_C$ = 3 s, V = 0.04 cm x 0.04 cm x 60 cm = 9.6x10$^{-4}$ m$^3$, $C_A$ = 60 x 0.00021/s = 1.2 x 10$^{-5}$ m$^3$/s, $A_s$ = 1 cm x 1 cm = 1 x 10$^{-4}$ m$^2$. (For the values for V and $C_A$, $\tau_V$ = 80 s). The time step size was 0.008 s. Despite the high value for $\tau_V$, the response of the manifold is quite similar to that shown in FIG. 10A, which shows the response for the same settings except with $\tau_V$ = 0.8 s ($C_A$=.1.2 x 10$^{-3}$ m$^3$/s). A minor effect of the large $\tau_V$ is the higher peak pressure value for the pressure pulses. The overall response, however is quite similar. FIGS. 13B and 13C illustrate how the area $A_s$ plays a role. The calculated pressure and temperature responses in FIGS. 13B and 13C were computed with the following settings: $T_b$= 373.16 K, $\tau_H$ = 1 s, $\tau_C$ = 3 s, V = 0.04 cm x 0.04 cm x 60 cm = 9.6x10$^{-4}$ m$^3$, and $A_s$ = 0.1 cm x 0.1 cm = 1 x 10$^{-6}$ m$^2$. $C_A$ was adjusted so that $\tau_V$ was 0.3 s in FIG. 13B and 8 s in FIG. 13C. $T_{max}$, $t_{off}$ and $t_{pulse}$ were adjusted to produce similar average pressure values with similar ratios of peak pressure to minimum pressure before the next pulse. The time step was adjusted to obtain a comparable number of heat pulses as $t_{off}$ increased. Additional calculations were performed in similar fashion with $C_A$ adjusted so that $\tau_V$ was 0.8, 3, and 4 s. The resultant $t_{off}$ required for sufficient decay of the heat pulses is plotted against $\tau_v$ in FIG. 14. As can be seen from FIGS. 13B, 13C, and 14, the significantly smaller (i.e. by a factor of 100) value for $A_s$ results in sensitivity of the response to the value of $\tau_v$. In this regime, the time between pulses must be set to roughly 5$\tau_v$, as the aperture conductance is now the limiting factor the decay of the manifold

pressure between pulses. Thus, the area of the evaporant in contact with the heating element in the vaporization zone can be increased to improve the response time of the manifold and to significantly reduce the dependence of the manifold response time on $\tau_v$.

Deposition using heat pulses can be achieved by constructing the manifold to deliver a uniform vapor flux over a specified substrate area or by combining a series of manifolds (FIG. 16), such as a row of elongated manifolds or an array of circular or square manifolds, or some combination thereof. Alternatively, sources without manifolds (FIGS. 15A and 15B) can be arranged to give uniform coatings.

Shown in FIG. 15A is a series of sources **20** are placed along a line beneath a substrate **22**. Depending on the degree of uniformity required, the distance h and the number of sources **20** can be chosen appropriately. Furthermore, the spacing d2 between sources near the edges of the substrate can be made smaller than the spacing d1 between sources further from the substrate edges. In addition, the relative deposition rates from the sources **20** can be adjusted to compensate for the finite length effects and consequent drop of thickness near the substrate edges. In particular, sources **20** at the ends can be operated at higher rate than those sources **20** that are further from the substrate edges, and some of those sources further from the substrate edge can be operated at lower rates relative to those sources near the center of the substrate. The relative rates of the various sources can thus be tailored to achieve better uniformity over the length of the substrate **22**. The sources **20** can be single material sources, multicomponent (i.e. mixed materials) sources, clusters of sources that deliver different materials simultaneously, or they can be single sources having multiple vaporization zones and thus delivering multiple materials simultaneously. Using pulsed deposition, the control of relative rates of the different materials as well as relative deposition rates from each of the sources along the substrate axis can be achieved by control of the material per pulse as described above, as well as the pulse frequency.

Shown in FIG. 15B is a top view of an array of sources **25** placed beneath a substrate **27**. As in FIG. 15A the spacing between sources near the substrate edges can be made smaller than the spacing between sources further from the substrate edge, and the number of sources and the distance between the plane of the sources and the substrate plane can be chosen depending on the degree of coating uniformity required. In addition the relative rates from each source can be adjusted depending on position to further improve the uniformity, as discussed for FIG. 15A, and the sources can be single material sources, multicomponent (i.e. mixed materials) sources, clusters of sources that deliver different materials simultaneously, or they can be single sources having multiple vaporization zones and thus delivering multiple materials simultaneously. Control of relative rates of the different materials as well as relative deposition rates from each of the sources can be achieved by control of the material per pulse as described above, as well as the pulse frequency.

Shown in FIG. 16 is a top view of an array of manifolds **30** placed beneath a substrate **32**. Each manifold **30** has an aperture **34** or plurality of apertures **34**, whose spacing and size are selected so as to produce uniform flux of material along some portion of the manifold length (width of the substrate). The size of the holes and the dimensions of the manifold are selected in accordance with the conductance criterion described in commonly assigned U.S. Patent Application Serial No. 10/352,558 filed January 28, 2003 by Jeremy M. Grace et al., entitled "Method of Designing a Thermal Physical Vapor Deposition System", the disclosure of which is herein incorporated by reference, so as to produce substantially uniform deposition thickness in the lengthwise direction. The manifolds **30** and array of apertures **34** can be longer or shorter than the substrate width, depending on the required uniformity. The spacing between manifolds **30** and the distance from the substrate to the manifold plane are chosen appropriately for the desired uniformity. The manifolds can be single material sources, multicomponent (i.e. mixed materials) sources, or they can be fed by multiple vaporization zones and thus deliver multiple materials simultaneously. Control of relative rates of the different materials as well as relative deposition rates from each of the manifolds can be achieved by control of the material per pulse as described above, as well as the pulse frequency. For codeposition of materials from separate manifolds, the manifolds **30** can also be tilted relative to the manifold-substrate normal so as to optimize mixing of vaporized material components as they travel between the manifold **30** and substrate **32**.

By precise control of the amount of material per pulse, the relative amounts of various components can be controlled. For example a host material that is to be dominant in the composition of the deposited film can be deposited using an intense pulse (high value of $T_{max}$) or a long pulse (long time $t_{pulse}$) and a dopant material that is to be a small fraction of the composition of the deposited film can be deposited using a weak pulse (low value of $T_{max}$) or a short pulse (short time $t_{pulse}$).

With appropriate construction of the vaporization region and heating element, the shape and size of the heat pulse will determine the amount of material deposited per pulse. Additional control over the relative amounts of components deposited in a film can be gained by delivering different numbers of pulses for each component. Pulse modulation (height or width) and differing pulse count can be used either to tailor the composition within a single layer or to tailor the relative thickness of two distinct layers, depending on the sequencing of the pulses from different vaporization zones. Various heat pulse sequences are illustrated in FIGS. 17A-C. In FIG. 17A, a sequence of heat pulses to deposit a combination of host (i.e. dominant component) and dopant (i.e. component in small concentrations compared to that of the host) by use of different pulse heights is shown. The host pulse **40** is considerably higher than dopant pulse **41**.

Consequently the layer deposited will have relative amounts of host and dopant in proportion to the area beneath each pulse in the pressure-time plot. In FIG. 17B, a pulse sequence to deposit host and dopant by pulse width variation is shown. The host pulse **44** is considerably longer than the dopant pulse **45**. When relative pulse height is used to control relative amounts of materials in a deposited film (as in FIG. 17A), the uniformity of film composition throughout the layer thickness is determined by the degree to which the pulse shapes are similar for the different materials being deposited. When relative pulse length is used to control the relative amounts of materials deposited (as in FIG. 17B), the composition varies over the thickness deposited per pulse, as the shorter pulse delivers its material for a fraction of the deposition time, while the longer pulse continues to deposit after the short pulse is delivered. In either case (i.e. FIGS. 17A and 17B), increasing the vapor time constant $\tau_v$ will improve the mixing of components, provided that $\tau_v$ is much longer than the larger pulse length and is the limiting time constant. In FIG. 17C, a pulse sequence to deposit two distinct layers is shown. A first material is deposited using heat pulses **48** followed by a second material deposited using heat pulses **49**. While only two components are shown in FIGS. 17A-17C, it should be apparent that multicomponent or multilayer films can be achieved using the same way illustrated in FIGS. 17A-17C by including heat pulses from additional sources and adjusting their pulse heights or pulse widths or timing relative to other pulses to achieve the desired composition or thickness control within a layer or in multilayer structures.

In the foregoing discussion, it should be appreciated that mechanical pulses can be used in place of or in combination with heat pulses to produce the deposition pulses and control their magnitudes. A mechanical pulse exerting a force of the depositing material against a heating element for a specified time will produce an amount of vaporized material that increases with the duration of the mechanical pulse, in analogous fashion to controlling the amount by heat pulse duration. Furthermore, combining mechanical and heat pulses, the time constant for vaporization to subside can be reduced relative to using heat pulses alone in cases where the cooling time constant $\tau_c$ is the limiting factor and is determined largely by the cooling response time of the heater.

The use of pulse modulation and sequencing to control deposited film thickness and composition limits the need to provide a constant and continuous material feed rate to the vaporization zone. As long as the conditions within the vaporization zone can be reset repeatably between pulses (during $t_{off}$), the intended controlled amount of material per pulse will be delivered. Furthermore, combining the pulse-wise deposition of material with stepwise motion of a substrate, the need to provide a constant substrate translation speed is limited. FIG. 18 shows control schemes where the generation of heat pulses is synchronized with the material feed and the substrate motion. A flash evaporation source **51** is placed between shields **52** defining a deposition zone **53**. A substrate **54** is mounted on a translation stage **55**, which is driven along a translation mechanism **56** by a motor **57**. A motor control unit **58** is used to control the motion of the stage **55**. A master control unit **60** (e.g. computer, microprocessor, etc.) sends control signals to the motor control unit **58**, a heat pulse generator **61**, and a material feed control unit **62**. By appropriate programming and logic, the motion of the substrate **54** is synchronized with the heat pulses and material feed to the flash evaporation source **51**. The substrate **54** is moved into position, a heat pulse sequence is applied to the flash evaporation source **51**, the evaporant material is advanced, or the feed mechanism is reset or repositioned, and the substrate **54** is then moved into the next position for the next deposition pulse sequence. The process is continued in synchronous stepwise motion until the substrate **54** and stage **55** have passed from one end of the deposition zone **53** to the other.

The flash evaporation source **51** can be as described in commonly assigned U.S. Patent Application Serial No. 10/784,585 filed February 23, 2004 by Michael Long et al., entitled "Device and Method for Vaporizing Temperature Sensitive Materials", the disclosure of which is herein incorporated by reference, or can be some other evaporation source having the capability to deliver pulses of material to be deposited. The substrate translation stage **55** and substrate **54** can include an assembly with masks and other fixtures to produce patterns in the deposited coating. The stage **55**, substrate **54**, and assembly can be translated with respect the source **51**, either by moving the substrate translation stage **55** or by moving the components defining the deposition zone **53** (i.e. source **51**, shields **52**, and any base plate or fixtures required to translate the deposition zone components together) with respect to the source **51**. There can be one or more sources **51** delivering similar or different materials, depending on the required composition and layer structure to be coated. The translation mechanism **56** thus can be position to move the substrate **54** and stage **55** or the source or sources **51** and their shielding **52** and other associated components.

The heat pulse generator **61** can be a closed loop heater control system with multiple outputs and multiple sensor (e.g., thermocouple or other temperature sensing device) inputs. One set of inputs and outputs can be used to maintain the base temperature $T_b$ described above. Control schemes can be proportional differential (PD) or proportional-integral-derivative (PID) control, with hardware or software implementation of the closed loop. In addition, feed forward control techniques can be used. For controlling steady state temperatures, heater output can be phase angle fired ac voltage, pulse width modulated dc voltage, asynchronous pulse width modulated ac voltage, or some other way of metering out available power to the heater. For pulsing the heater element (not shown) of source **51**, additional outputs and sensors inputs can be used. These heat pulses are used to produce the vapor pulses as described above. Furthermore, additional sensor inputs and heater outputs can be used to maintain the required temperatures on the manifold (not shown) and the aperture surfaces (not shown) of the source **51** using any of a variety of control schemes as described

above.

The material feed control unit **62** can be a closed loop control system with multiple sensor inputs and control signal outputs to control one or more material feed mechanisms (not shown). Sensors within the feed mechanism (e.g. to sense force, strain, velocity, displacement, temperature of heating element within source **51**, etc.) can be used to control feed rate by use of the control unit **62** employing PD, PID, state variable, feed forward, or other control schemes. Furthermore, the material feed control unit **62** can deliver control pulses to the material feed mechanism in synchronization with heat pulses from the heat pulse generator **61** and substrate motion driven by motor control unit **58**. Depending on the feed mechanism, control pulses can not only pause the feeding of material, but also can retract the material or reduce contact with heating elements within the source **51** to accelerate the decay of the vapor pulses delivered by source **51**. Alternatively, the control pulses can result in the metering of a desired amount of material in a given cycle.

The motor control unit **58** can be a motion control system with appropriate motion and position sensors and actuators. Synchronization of the substrate **54** motion with heat pulses and material feed is accomplished by communication between the control units **58**, **61**, **62** and the master control unit **60**.

In order to illustrate the concept of depositing uniform layers using synchronous stepwise motion of the substrate and heat pulsing, a model was constructed. This model calculates the coating uniformity along the direction of motion of a substrate moved in stepwise fashion across a deposition zone containing a source that emits a vapor plume of specified shape.

The geometry relevant to the model is shown in FIG. 19. A I deposition zone **70** is defined by vertical shields **71** placed at positions $+L_z/2$ and $-L_z/2$ with respect to the center of the deposition source **73**. A vapor plume **75** is emitted from the source when heat pulses are applied. A substrate **77** is moved in stepwise fashion with a step size equal to $L_z/s$, where s is the number of steps required to traverse the deposition zone. The effect of the plume shape is expressed as a function of angle θ between the vertical distance d to the substrate **77** and the radial distance from the center of the source **73** to a point x on the substrate **77**:

$$R \propto \cos^{p}(\theta) \qquad (5)$$

where R is the deposition rate and p is a plume shape exponent. Using the relation cos(θ)=d/r, one finds:

$$R \propto \frac{\cos^{p+q+1}(\theta)}{d^{q}} \qquad (6)$$

where q = 1 for a line source, q = 2 for a point source, and the additional 1 in the exponent arises from the dot product of the deposition flux with the substrate normal. Using Eq. 6, the relative amount of material deposited along a substrate segment moving in s steps is found by integrating the relative rate R along the step size (expressing θ as a function of x and integrating over x values along the substrate step), moving the substrate by a step $L_z/s$ in the x direction, integrating R again, and accumulating all the contributions along the step size for all s steps. From the resultant distribution of material along the step length, the nonuniformity along the substrate (defined here as the range of the thickness values divided by the average of the values) is calculated to be *2(max-min)/(max+min)*, where min and max are respectively the minimum and maximum accumulated thicknesses along the substrate segment. Input parameters to the model are $L_z$, d, p, q, and s.

Shown in FIG. 20 are three deposition profiles along the substrate segment Lz/s. These profiles were calculated using d=10 cm, Lz=40 cm, and p=1.5. The highly peaked profile is for the case s=1 and reveals the plume shape used in obtaining the modeled profile. The u-shaped profile is for the case s=2, where the edges of the substrate are exposed to the maximum deposition rate (x=0) as the step size is half the length of the deposition zone. The flat profile is for the case s=6 and is considerably uniform (nonuniformity = 0.003, or 0.3%).

FIGS. 21 and 22 show the results for calculated nonuniformity as a function of number of steps s for two plume shapes and two vertical distances d, respectively for a line source (q=1) and a point source (q=2). In FIG. 21, calculations are for p=1.5 and d=10 (•), p=20 and d=10 (▲), p=1.5 and d=4 (o), and p=20 and d=4 (Δ). In FIG. 22, calculations are for p=1.5 and d=10 (♦), p=20 and d=10 (■), p=1.5 and d=4 (0), and p=20 and d=4 (□). As can be seen from FIGS. 21 and 22, for minimum number of steps and lowest nonuniformity, a broader plume (lower value of p) is preferred. FIGS. 21 and 22 also show that similar results are obtained for point source and linear sources under the conditions modeled.

Turning now to FIG. 23, there is shown a cross-sectional view of a flash evaporation source suitable for pulsed evaporation and synchronous pulsed evaporation and substrate motion of the present invention. Vaporization apparatus **80** vaporizes materials onto a substrate surface to form a film, and includes a first heating region **82** and a second

heating region **84** spaced from first heating region **82**. First heating region **82** includes a first heating arrangement represented by base block **85**, which can be a heating base block or a cooling base block, or both, and which can include control passage **86**. Second heating region **84** includes the region bounded by manifold **88** and heating element **87**, which can be part of manifold **88**. The heating element **87** can be permeable or can be otherwise shaped to permit vaporized material to escape in the direction of the manifold **88**. A feature of the heating element **87** is its response time, which not only depends on its construction but also depends on its thermal contact to the base block **85** through fixturing and the material **92**. Shorter response time enables higher frequency pulsing of the heating element **87**. Manifold **88** also includes one or more apertures **89**. The region of the manifold **88** having the apertures **89** can be separately heated to ensure that the exit surfaces of the manifold (i.e. inner walls of apertures **89** and surfaces of manifold **88** near the apertures **89**) are sufficiently hot so as to avoid condensation of vapor and consequent obstruction of the exit volume. Chamber **90** can receive a quantity of material **92** (i.e. evaporant, sublimate, material to be deposited). A way of metering material **92** includes chamber **90** for receiving the material **92**, piston **95** for raising material **92** in chamber **90**, as well as heating element **87**.

A drive unit **96** advances the piston. For extended runs, the piston **95** and drive unit **96** can be replaced by a mechanism for continuous feed of powder, solid formed from compressed or melt cast material, or liquid. A drive control unit **97** provides control signals to the drive unit **96** and can be used to program the motion of the piston **95** or to control the metering of material by an alternative material feed mechanism. A heating element control unit **98** provides current or voltage waveforms (i.e. pulses, alternating-current, or direct-current voltages or currents) to the heating element **87**. Additional heater control units (not shown) maintain the manifold **88** and base block **85** at their respective constant temperatures. Vaporization apparatus **80** can include one or more radiation shields **100**.

Material **92** is preferably either a compacted or precondensed solid. However, material in powder form is also acceptable. Material **92** can comprise a single component, or can comprise two or more components, each one having a different vaporization temperature. Material **92** is in close thermal contact with the first heating arrangement that is base block **85**. Control passages **86** through this block permit the flow of a temperature control fluid, that is, a fluid adapted to either absorb heat from or deliver heat to the first heating region **82**. The fluid can be a gas or a liquid or a mixed phase. Vaporization apparatus **80** pumps fluid through control passages **86**. Applicable pumping arrangements, not shown, are well known to those skilled in the art. Material **92** is heated in first heating region **82** until it is at the desired base temperature $T_b$ as described above. First heating region **82** is maintained at a constant temperature as material **92** is consumed.

Material **92** is metered at a controlled rate from first heating region **82** to second heating region **84**. Second heating region **84** is heated to a temperature above the desired vaporization temperature $T_v$ discussed above. The temperature of first heating region **82** is maintained at $T_b$, while the temperature of second heating region **84** is at or above the desired rate-dependent vaporization temperature $T_v$. In this embodiment, second heating region **84** includes the region bounded by manifold **88**. Material **92** is pushed against heating element **87** by piston **95**. The heating element **87** or the piston **95** or alternative feed mechanism or both can be pulsed by their respective control units **97** and **98**.

Where a manifold **88** is used, a pressure develops as described above and vapor exits the manifold **88** through the series of apertures **89**. The conductance along the length of the manifold is designed to be roughly two orders of magnitude larger than the sum of the aperture conductances as described in commonly assigned U.S. Patent Application Serial No. 10/352,558 filed January 28, 2003 by Jeremy M. Grace et al., entitled "Method of Designing a Thermal Physical Vapor Deposition System", the disclosure of which is herein incorporated by reference. This conductance ratio promotes effective pressure uniformity within manifold **88** and thereby reduces flow nonuniformities through apertures **89** distributed along the length of the source despite potential local nonuniformities in pressure.

One or more radiation shields **100** are located adjacent the heated manifold **88** for the purpose of reducing the heat radiated to the facing target substrate. These heat shields are thermally connected to base block **85** for the purpose of drawing heat away from the shields. The upper portion of shields **100** is designed to lie below the plane of the apertures for the purpose of reducing vapor condensation on their relatively cool surfaces.

Because only a small portion of material **92**, the portion resident in second heating region **84** and nearest the heating element **87**, is heated to $T_v$, while the bulk of the material is kept well below $T_v$, it is possible to interrupt the vaporization by way of interrupting heating in the second heating region **84**, e.g. turning off the heat supply to the heating element **87** or stopping the movement of piston 95 (or alternative material feed mechanism), actively withdrawing material from the second heating region **84** or heating element **87**, or includes turning off the heat supply and mechanical manipulation of the material.

Because the heating element **87** can be a fine mesh screen that prevents powder or compacted material from passing freely through it, vaporization apparatus **80** can be used in any orientation. For example, vaporization apparatus **80** can be oriented 180° from what is shown in FIG. 18 so as to coat a substrate placed below it. This is an advantage not found in the heating boats of the prior art.

Although one preferred embodiment has been the use of vaporization apparatus **80** with a powder or compressed material that sublimes when heated, in some embodiments material **92** can be a material that liquefies before vaporization,

and can be a liquid at the temperature of first heating region **82**. In such a case, heating element **87** can absorb and retain liquefied material **92** in a controllable manner via capillary action, thus permitting control of vaporization rate.

Because the pressure in a pulsed flash evaporation source (such a depicted in FIG. 23, or some other source wherein material is vaporized in pulses and introduced into a deposition zone beneath a substrate) is not constant, the conductance to vapor flow will vary with time to the extent that a pressure dependent conductance exists (e.g. in transition or molecular flow). When a manifold is used, it can be desirable to introduce an inert gas into the manifold to keep the pressure inside the manifold sufficiently high to maintain the low conductance ratio (conductance of vapor flow exiting the manifold to conductance of vapor flow within the manifold). Argon and nitrogen can be used for this purpose, as well as any gas known not to react unfavorably with the material to be deposited or any gas known to react favorably with the material to be deposited (such as commonly done in reactive evaporation or reactive sputtering other reactive deposition technologies).

Other embodiments of flash evaporation sources suitable for pulse-mode operation include sources wherein material to be deposited is introduced in aerosol form, nanoparticulate form, entrained in a stream of carrier gas, wire form, rod form, or liquid form.

Turning now to FIG. 24, there is shown a cross-sectional view of a pixel of a light-emitting OLED device **110** that can be prepared in part according to the present invention. The OLED device **110** includes at a minimum a substrate **120**, a cathode **190**, an anode **130** spaced from cathode **190**, and a light-emitting layer **150**. The OLED device can also include a hole-injecting layer **135**, a hole-transporting layer **140**, an electron-transporting layer **155**, and an electron-injecting layer **160**. Hole-injecting layer **135**, hole-transporting layer **140**, light-emitting layer **150**, electron-transporting layer **155**, and electron-injecting layer **160** comprise a series of organic layers **170** disposed between anode **130** and cathode **190**. Organic layers **170** are the layers most desirably deposited by the device and method as set forth in the attached claims. These components will be described in more detail.

Substrate **120** can be an organic solid, an inorganic solid, or include organic and inorganic solids. Substrate **120** can be rigid or flexible and can be processed as separate individual pieces, such as sheets or wafers, or as a continuous roll. Typical substrate materials include glass, plastic, metal, ceramic, semiconductor, metal oxide, semiconductor oxide, semiconductor nitride, or combinations thereof. Substrate **120** can be a homogeneous mixture of materials, a composite of materials, or multiple layers of materials. Substrate **120** can be an OLED substrate, that is a substrate commonly used for preparing OLED devices, e.g. active-matrix low-temperature polysilicon or amorphous-silicon TFT substrate. The substrate **120** can either be light transmissive or opaque, depending on the intended direction of light emission. The light transmissive property is desirable for viewing the EL emission through the substrate. Transparent glass or plastic are commonly employed in such cases. For applications where the EL emission is viewed through the top electrode, the transmissive characteristic of the bottom support is immaterial, and therefore can be light transmissive, light absorbing or light reflective. Substrates for use in this case include, but are not limited to, glass, plastic, semiconductor materials, ceramics, and circuit board materials, or any others commonly used in the formation of OLED devices, which can be either passive-matrix devices or active-matrix devices.

An electrode is formed over substrate **120** and is most commonly configured as an anode **130**. When EL emission is viewed through the substrate **120**, anode **130** should be transparent or substantially transparent to the emission of interest. Common transparent anode materials useful in this invention are indium-tin oxide and tin oxide, but other metal oxides can work including, but not limited to, aluminum- or indium-doped zinc oxide, magnesium-indium oxide, and nickel-tungsten oxide. In addition to these oxides, metal nitrides such as gallium nitride, metal selenides such as zinc selenide, and metal sulfides such as zinc sulfide, can be used as an anode material. For applications where EL emission is viewed through the top electrode, the transmissive characteristics of the anode material are immaterial and any conductive material can be used, transparent, opaque or reflective. Example conductors for this application include, but are not limited to, gold, iridium, molybdenum, palladium, and platinum. The preferred anode materials, transmissive or otherwise, have a work function of 4.1 eV or greater. Desired anode materials can be deposited by any suitable way such as evaporation, sputtering, chemical vapor deposition, or electrochemical processes. Anode materials can be patterned using well known photolithographic processes.

While not always necessary, it is often useful that a hole-injecting layer **135** be formed over anode **130** in an organic light-emitting display. The hole-injecting material can serve to improve the film formation property of subsequent organic layers and to facilitate injection of holes into the hole-transporting layer. Suitable materials for use in hole-injecting layer **135** include, but are not limited to, porphyrinic compounds as described in U.S. Patent 4,720,432, plasma-deposited fluorocarbon polymers as described in U.S. Patent 6,208,075, and inorganic oxides including vanadium oxide (VOx), molybdenum oxide (MoOx), nickel oxide (NiOx), etc. Alternative hole-injecting materials reportedly useful in organic EL devices are described in EP 0 891 121 A1 and EP 1 029 909 A1.

While not always necessary, it is often useful that a hole-transporting layer **140** be formed and disposed over anode **130**. Desired hole-transporting materials can be deposited by any suitable way such as evaporation, sputtering, chemical vapor deposition, electrochemical processes, thermal transfer, or laser thermal transfer from a donor material, and can be deposited by the device and method described herein. Hole-transporting materials useful in hole-transporting

layer **140** are well known to include compounds such as an aromatic tertiary amine, where the latter is understood to be a compound containing at least one trivalent nitrogen atom that is bonded only to carbon atoms, at least one of which is a member of an aromatic ring. In one form the aromatic tertiary amine can be an arylamine, such as a monoarylamine, diarylamine, triarylamine, or a polymeric arylamine. Exemplary monomeric triarylamines are illustrated by Klupfel et al. in U.S. Patent 3,180,730. Other suitable triarylamines substituted with one or more vinyl radicals and/or comprising at least one active hydrogencontaining group are disclosed by Brantley et al. in U.S. Patents 3,567,450 and 3,658,520.

A more preferred class of aromatic tertiary amines are those which include at least two aromatic tertiary amine moieties as described in U.S. Patents 4,720,432 and 5,061,569. Such compounds include those represented by structural Formula A

A 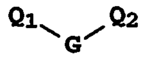

wherein:

$Q_1$ and $Q_2$ are independently selected aromatic tertiary amine moieties; and
G is a linking group such as an arylene, cycloalkylene, or alkylene group of a carbon to carbon bond.

In one embodiment, at least one of Q1 or Q2 contains a polycyclic fused ring structure, e.g., a naphthalene. When G is an aryl group, it is conveniently a phenylene, biphenylene, or naphthalene moiety.

A useful class of triarylamines satisfying structural Formula A and containing two triarylamine moieties is represented by structural Formula B

B 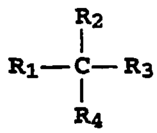

where:

$R_1$ and $R_2$ each independently represent a hydrogen atom, an aryl group, or an alkyl group or $R_1$ and $R_2$ together represent the atoms completing a cycloalkyl group; and
$R_3$ and $R_4$ each independently represent an aryl group, which is in turn substituted with a diaryl substituted amino group, as indicated by structural Formula C

C 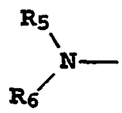

wherein $R_5$ and $R_6$ are independently selected aryl groups. In one embodiment, at least one of $R_5$ or $R_6$ contains a polycyclic fused ring structure, e.g., a naphthalene.

Another class of aromatic tertiary amines are the tetraaryldiamines. Desirable tetraaryldiamines include two diarylamino groups, such as indicated by Formula C, linked through an arylene group. Useful tetraaryldiamines include those represented by Formula D

D 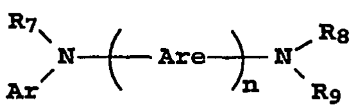

wherein:

each Are is an independently selected arylene group, such as a phenylene or anthracene moiety;
n is an integer of from 1 to 4; and
Ar, $R_7$, $R_8$, and $R_9$ are independently selected aryl groups.

In a typical embodiment, at least one of Ar, $R_7$, $R_8$, and $R_9$ is a polycyclic fused ring structure, e.g., a naphthalene.
The various alkyl, alkylene, aryl, and arylene moieties of the foregoing structural Formulae A, B, C, D, can each in turn be substituted. Typical substituents include alkyl groups, alkoxy groups, aryl groups, aryloxy groups, and halogens such as fluoride, chloride, and bromide. The various alkyl and alkylene moieties typically contain from 1 to about 6 carbon atoms. The cycloalkyl moieties can contain from 3 to about 10 carbon atoms, but typically contain five, six, or seven carbon atoms--e.g., cyclopentyl, cyclohexyl, and cycloheptyl ring structures. The aryl and arylene moieties are usually phenyl and phenylene moieties.
The hole-transporting layer in an OLED device can be formed of a single or a mixture of aromatic tertiary amine compounds. Specifically, one can employ a triarylamine, such as a triarylamine satisfying the Formula B, in combination with a tetraaryldiamine, such as indicated by Formula D. When a triarylamine is employed in combination with a tetraaryldiamine, the latter is positioned as a layer interposed between the triarylamine and the electron-injecting and transporting layer. The device and method described herein can be used to deposit single- or multi-component layers, and can be used to sequentially deposit multiple layers.
Another class of useful hole-transporting materials includes polycyclic aromatic compounds as described in EP 1 009 041. In addition, polymeric hole-transporting materials can be used such as poly(N-vinylcarbazole) (PVK), polythiophenes, polypyrrole, polyaniline, and copolymers such as poly(3,4-ethylenedioxythiophene)/poly(4-styrenesulfonate) also called PEDOT/PSS.
Light-emitting layer **150** produces light in response to hole-electron recombination. Light-emitting layer **150** is commonly disposed over hole-transporting layer **140**. Desired organic light-emitting materials can be deposited by any suitable way such as evaporation, sputtering, chemical vapor deposition, electrochemical processes, or radiation thermal transfer from a donor material, and can be deposited by the device and method described herein. Useful organic light-emitting materials are well known. As more fully described in U.S. Patents 4,769,292 and 5,935,721, the light-emitting layers of the organic EL element comprise a luminescent or fluorescent material where electroluminescence is produced as a result of electron-hole pair recombination in this region. The light-emitting layers can be comprised of a single material, but more commonly include a host material doped with a guest compound or dopant where light emission comes primarily from the dopant. The dopant is selected to produce color light having a particular spectrum. The host materials in the light-emitting layers can be an electron-transporting material, as defined below, a hole-transporting material, as defined above, or another material that supports hole-electron recombination. The dopant is usually chosen from highly fluorescent dyes, but phosphorescent compounds, e.g., transition metal complexes as described in WO 98/55561, WO 00/18851, WO 00/57676, and WO 00/70655 are also useful. Dopants are typically coated as 0.01 to 10 % by weight into the host material. The device and method described herein can be used to coat multi-component guest/host layers without the need for multiple vaporization sources.
Host and emitting molecules known to be of use include, but are not limited to, those disclosed in U.S. Patents 4,768,292; 5,141,671; 5,150,006; 5,151,629; 5,294,870; 5,405,709; 5,484,922; 5,593,788; 5,645,948; 5,683,823; 5,755,999; 5,928,802; 5,935,720; 5,935,721; and 6,020,078.
Metal complexes of 8-hydroxyquinoline and similar derivatives (Formula E) constitute one class of useful host materials capable of supporting electroluminescence, and are particularly suitable for light emission of wavelengths longer than 500 nm, e.g., green, yellow, orange, and red.

E

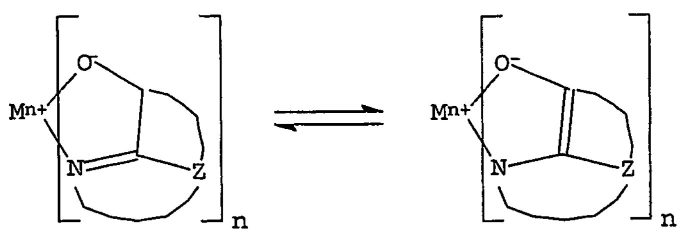

wherein:

M represents a metal;
n is an integer of from 1 to 3; and
Z independently in each occurrence represents the atoms completing a nucleus having at least two fused aromatic

rings.

From the foregoing it is apparent that the metal can be a monovalent, divalent, or trivalent metal. The metal can, for example, be an alkali metal, such as lithium, sodium, or potassium; an alkaline earth metal, such as magnesium or calcium; or an earth metal, such as boron or aluminum. Generally any monovalent, divalent, or trivalent metal known to be a useful chelating metal can be employed.

Z completes a heterocyclic nucleus containing at least two fused aromatic rings, at least one of which is an azole or azine ring. Additional rings, including both aliphatic and aromatic rings, can be fused with the two required rings, if required. To avoid adding molecular bulk without improving on function the number of ring atoms is usually maintained at 18 or less.

The host material in light-emitting layer 150 can be an anthracene derivative having hydrocarbon or substituted hydrocarbon substituents at the 9 and 10 positions. For example, derivatives of 9,10-di-(2-naphthyl)anthracene constitute one class of useful host materials capable of supporting electroluminescence, and are particularly suitable for light emission of wavelengths longer than 400 nm, e.g., blue, green, yellow, orange or red.

Benzazole derivatives constitute another class of useful host materials capable of supporting electroluminescence, and are particularly suitable for light emission of wavelengths longer than 400 nm, e.g., blue, green, yellow, orange or red. An example of a useful benzazole is 2, 2', 2"-(1,3,5-phenylene)-tris[1-phenyl-1H-benzimidazole].

Desirable fluorescent dopants include perylene or derivatives of perylene, derivatives of anthracene, tetracene, xanthene, rubrene, coumarin, rhodamine, quinacridone, dicyanomethylenepyran compounds, thiopyran compounds, polymethine compounds, pyrilium and thiapyrilium compounds, derivatives of distryrylbenzene or distyrylbiphenyl, bis (azinyl)methane boron complex compounds, and carbostyryl compounds.

Other organic emissive materials can be polymeric substances, e.g. polyphenylenevinylene derivatives, dialkoxy-polyphenylenevinylenes, poly-para-phenylene derivatives, and polyfluorene derivatives, as taught by Wolk et al. in commonly assigned U.S. Patent 6,194,119 B1 and references cited therein.

While not always necessary, it is often useful that OLED device **110** includes an electron-transporting layer 155 disposed over light-emitting layer **150**.b Desired electron-transporting materials can be deposited by any suitable way such as evaporation, sputtering, chemical vapor deposition, electrochemical processes, thermal transfer, or laser thermal transfer from a donor material, and can be deposited by the device and method described herein. Preferred electron-transporting materials for use in electron-transporting layer **155** are metal chelated oxinoid compounds, including chelates of oxine itself (also commonly referred to as 8-quinolinol or 8-hydroxyquinoline). Such compounds help to inject and transport electrons and exhibit both high levels of performance and are readily fabricated in the form of thin films. Exemplary of contemplated oxinoid compounds are those satisfying structural Formula E, previously described.

Other electron-transporting materials include various butadiene derivatives as disclosed in U.S. Patent 4,356,429 and various heterocyclic optical brighteners as described in U.S. Patent 4,539,507. Benzazoles satisfying structural Formula G are also useful electron-transporting materials.

Other electron-transporting materials can be polymeric substances, e.g. polyphenylenevinylene derivatives, poly-para-phenylene derivatives, polyfluorene derivatives, polythiophenes, polyacetylenes, and other conductive polymeric organic materials such as those listed in Handbook of Conductive Molecules and Polymers, Vols. 1-4, H.S. Nalwa, ed., John Wiley and Sons, Chichester (1997).

An electron-injecting layer **160** can also be present between the cathode and the electron-transporting layer. Examples of electron-injecting materials include alkaline or alkaline earth metals, alkali halide salts, such as LiF mentioned above, or alkaline or alkaline earth metal doped organic layers.

Cathode **190** is formed over the electron-transporting layer **155** or over light-emitting layer **150** if an electron-transporting layer is not used. When light emission is through the anode **130**, the cathode material can be comprised of nearly any conductive material. Desirable materials have effective film-forming properties to ensure effective contact with the underlying organic layer, promote electron injection at low voltage, and have effective stability. Useful cathode materials often contain a low work function metal (< 3.0 eV) or metal alloy. One preferred cathode material is comprised of a Mg:Ag alloy wherein the percentage of silver is in the range of 1 to 20 %, as described in U.S. Patent 4,885,221. Another suitable class of cathode materials includes bilayers comprised of a thin layer of a low work function metal or metal salt capped with a thicker layer of conductive metal. One such cathode is comprised of a thin layer of LiF followed by a thicker layer of A1 as described in U.S. Patent 5,677,572. Other useful cathode materials include, but are not limited to, those disclosed in U.S. Patents 5,059,861; 5,059,862; and 6,140,763.

When light emission is viewed through cathode **190**, it must be transparent or nearly transparent. For such applications, metals must be thin or one must use transparent conductive oxides, or include these materials. Optically transparent cathodes have been described in more detail in U.S. Patent 5,776,623. Cathode materials can be deposited by evaporation, sputtering, or chemical vapor deposition. When needed, patterning can be achieved through many well known methods including, but not limited to, through-mask deposition, integral shadow masking as described in U.S. Patent 5,276,380 and EP 0 732 868, laser ablation, and selective chemical vapor deposition.

Cathode materials can be deposited by evaporation, sputtering, or chemical vapor deposition. When needed, patterning can be achieved through many well known methods including, but not limited to, through-mask deposition, integral shadow masking as described in U.S. Patent 5,276,380 and EP 0 732 868, laser ablation, and selective chemical vapor deposition.

In addition to deposition of organic materials (in particular for OLED devices), the invention can also be used to deposit organic materials for other applications in similar fashion. For high-temperature materials (i.e. materials requiring temperatures in excess of 800 K to obtain useful vapor pressures), it can be desirable to omit the manifold and to have an array of heat pulse vaporization sources (linear or two-dimensional) to achieve the desired coating uniformity over a large substrate without subjecting said substrate to excessive heating from the manifold. Alternatively, the manifold can be housed inside a heat shield or a plurality of heat shields, the outermost of which can be cooled so as to prevent excessive radiant heating of the substrate during deposition.

**PARTS LIST**

| | |
|---|---|
| 1 | deposition source |
| 2 | manifold |
| 3 | exit surface |
| 4 | aperture |
| 5 | evaporant |
| 6 | vaporization region |
| 7 | heating element |
| 8 | region of lower temperature |
| 9 | heat pulse |
| 20 | sources |
| 22 | substrate |
| 25 | sources |
| 27 | substrate |
| 30 | manifold |
| 32 | substrate |
| 34 | aperture |
| 40 | host pulse |
| 41 | dopant pulse |
| 44 | host pulse |
| 45 | dopant pulse |
| 48 | heat pulses |
| 49 | heat pulses |
| 51 | flash evaporation source |
| 52 | shields |
| 53 | deposition zone |
| 54 | substrate |
| 55 | translation stage |
| 56 | translation mechanism |
| 57 | motor |
| 58 | motor control unit |
| 60 | master control unit |
| 61 | heat pulse generator |
| 62 | material feed control unit |
| 70 | deposition zone |
| 71 | vertical shields |
| 73 | deposition source |
| 75 | vapor plume |
| 77 | substrate |
| 80 | vaporization apparatus |
| 82 | first heating region |
| 84 | second heating region |
| 85 | base block |

86 control passage
87 heating element
88 manifold
89 aperture(s)
90 chamber
92 material
95 piston
96 drive unit
97 drive control unit
98 heating element control unit
100 radiation shields
110 OLED device
120 substrate
130 anode
135 hole-injecting layer
140 hole-transporting layer
150 light-emitting layer
155 electron-transporting layer
160 electron-injecting layer
170 organic layers
190 cathode

**Claims**

**1.** A method for vaporizing organic material onto a substrate surface deposit an organic film of controlled thickness and uniformity, comprising:

a) providing a quantity of organic material into a vaporization apparatus that defines a deposition zone;
b) actively maintaining the organic material in the vaporization apparatus at a base temperature $T_b$;
c) applying a heat pulse to a portion of the organic material by providing a current pulse to a heater to raise the temperature of such material portion to a temperature $T_v$ which is greater than $T_b$, thereby causing such material portion to vaporize as a vapor pulse and be applied onto a predetermined portion of the substrate surface that is exposed to the vaporized material in the deposition zone;
d) providing stepwise motion to the substrate, wherein the motion is a predetermined fraction of the deposition zone, thereby changing the position of the substrate surface relative to the deposition zone; and
e) repeating steps c) and d) one or more times until the substrate has passed from one end of the deposition zone to the other to deposit an organic film of controlled thickness and uniformity on the substrate surface.

**2.** The method according to claim 1 wherein the vaporization apparatus includes a manifold through which vaporized material passes to coat the substrate.

**3.** The method according to claim 1 further including metering the material into the vaporization apparatus.

**4.** The method according to claim 3 wherein the material metering step is related to the timing of the heat pulses.

**5.** The method according to claim 1 wherein an indexing of the substrate is related to the timing of the heat pulses.

**6.** The method according to claim 2 further including applying an inert gas into the manifold to maintain conductance within the manifold.

**7.** The method according to claim 1 further including controlling the pulse height or pulse width.

**8.** The method according to claim 1 wherein the heat pulse is provided by a mechanical pulse of a material feed mechanism to bring material into sudden contact with a source of heat.

**9.** The method according to claim 1 wherein the heat pulse is provided by a pulse of a material feed mechanism and a current pulse to a heater.

## Patentansprüche

1. Verfahren zum Aufdampfen von organischem Material auf eine Substratoberfläche zur Abscheidung eines organischen Films von kontrollierter Dicke und Gleichmäßigkeit, umfassend:

    a) Vorsehen einer Menge an organischem Material in einer Verdampfungsvorrichtung, welche eine Abscheidungszone bildet;
    b) aktives Halten des organischen Materials in der Verdampfungsvorrichtung bei einer Basistemperatur $T_b$;
    c) Anwenden eines Wärmeimpulses auf einen Anteil des organischen Materials durch Vermitteln eines Stromimpulses an eine Heizvorrichtung, um die Temperatur eines solchen Materialanteils auf eine Temperatur $T_v$, die höher als $T_b$ ist, zu erhöhen, wodurch bewirkt wird, dass ein solcher Materialanteil als ein Dampfimpuls verdampft und auf einen vorbestimmten Bereich der Substratoberfläche aufgetragen wird, der dem verdampften Material in der Abscheidungszone ausgesetzt ist;
    d) Vorsehen einer stufenweisen Bewegung des Substrats, wobei die Bewegung eine vorbestimmte Fraktion der Abscheidungszone ist, wodurch die Position der Substratoberfläche im Verhältnis zu der Abscheidungszone verändert wird; und
    e) Wiederholen der Schritte c) und d) einmal oder mehrmals, bis das Substrat von einem Ende der Abscheidungszone zu dem anderen geführt wurde zur Abscheidung eines organischen Films von regulierter Dicke und Gleichmäßigkeit auf der Substratoberfläche.

2. Verfahren gemäß Anspruch 1, wobei die Verdampfungsvorrichtung ein Verteilerstück bzw. Manifold einschließt, durch welches verdampftes Material geleitet wird zur Beschichtung des Substrats.

3. Verfahren gemäß Anspruch 1, weiterhin einschließend das Zuteilen des Materials in die Verdampfungsvorrichtung.

4. Verfahren gemäß Anspruch 3, wobei der Material-Zuteilungsschritt mit der zeitlichen Abstimmung der Wärmeimpulse in Zusammenhang steht.

5. Verfahren gemäß Anspruch 1, wobei ein Indizieren des Substrats mit der zeitlichen Abstimmung der Wärmeimpulse in Zusammenhang steht.

6. Verfahren gemäß Anspruch 2, weiterhin einschließend das Einbringen eines Inertgases in das Verteilerstück, um die Leitfähigkeit innerhalb des Verteilerstücks aufrechtzuerhalten.

7. Verfahren gemäß Anspruch 1, weiterhin einschließend das Regulieren der Impulshöhe oder Impulsbreite.

8. Verfahren gemäß Anspruch 1, wobei der Wärmeimpuls durch einen mechanischen Impuls eines Materialzuführmechanismus bereitgestellt wird, um Material mit einer Wärmequelle in schlagartigen Kontakt zu bringen.

9. Verfahren gemäß Anspruch 1, wobei der Wärmeimpuls durch einen Impuls eines Materialzuführmechanismus und einen Stromimpuls an eine Heizvorrichtung vorgesehen wird.

## Revendications

1. Procédé pour vaporiser un matériau organique sur une surface de substrat afin de déposer un film organique d'épaisseur et d'uniformité contrôlées, comprenant les étapes consistant à :

    a) fournir une quantité de matériau organique dans un appareil de vaporisation qui définit une zone de dépôt ;
    b) maintenir activement le matériau organique dans l'appareil de vaporisation à une température de base $T_b$ ;
    c) appliquer une impulsion de chaleur à une partie du matériau organique en délivrant une impulsion de courant à un élément chauffant pour porter la température de cette partie du matériau à une température $T_v$ qui est supérieure à $T_b$, de manière à faire que cette partie de matériau se vaporise sous forme d'impulsion de vapeur et soit appliquée sur une partie prédéterminée de la surface du substrat qui est exposée au matériau vaporisé dans la zone de dépôt ;
    d) transmettre un mouvement pas à pas au substrat, dans lequel le mouvement est une fraction prédéterminée de la zone de dépôt, de manière à changer la position de la surface du substrat par rapport à la zone de dépôt ; et
    e) répéter les étapes c) et d) une ou plusieurs fois jusqu'à ce que le substrat soit passé d'une extrémité de la

zone de dépôt à l'autre pour déposer un film organique d'épaisseur et d'uniformité contrôlées sur la surface du substrat.

2. Procédé selon la revendication 1, dans lequel l'appareil de vaporisation comprend une rampe à travers laquelle du matériau vaporisé passe pour revêtir le substrat.

3. Procédé selon la revendication 1, comprenant en outre le dosage du matériau dans l'appareil de vaporisation.

4. Procédé selon la revendication 3, dans lequel l'étape de dosage du matériau est liée à la temporisation des impulsions de chaleur.

5. Procédé selon la revendication 1, dans lequel un indexage du substrat est lié à la temporisation des impulsions de chaleur.

6. Procédé selon la revendication 2, comprenant en outre l'application d'un gaz inerte à l'intérieur de la rampe pour maintenir une conductance à l'intérieur de la rampe.

7. Procédé selon la revendication 1, comprenant en outre le contrôle de la hauteur d'impulsions ou de la largeur d'impulsions.

8. Procédé selon la revendication 1, dans lequel l'impulsion de chaleur est fournie par une impulsion mécanique d'un mécanisme d'alimentation en matériau pour mettre le matériau en contact soudain avec une source de chaleur.

9. Procédé selon la revendication 1, dans lequel l'impulsion de chaleur est fournie par une impulsion d'un mécanisme d'alimentation en matériau et une impulsion de courant à un élément chauffant.

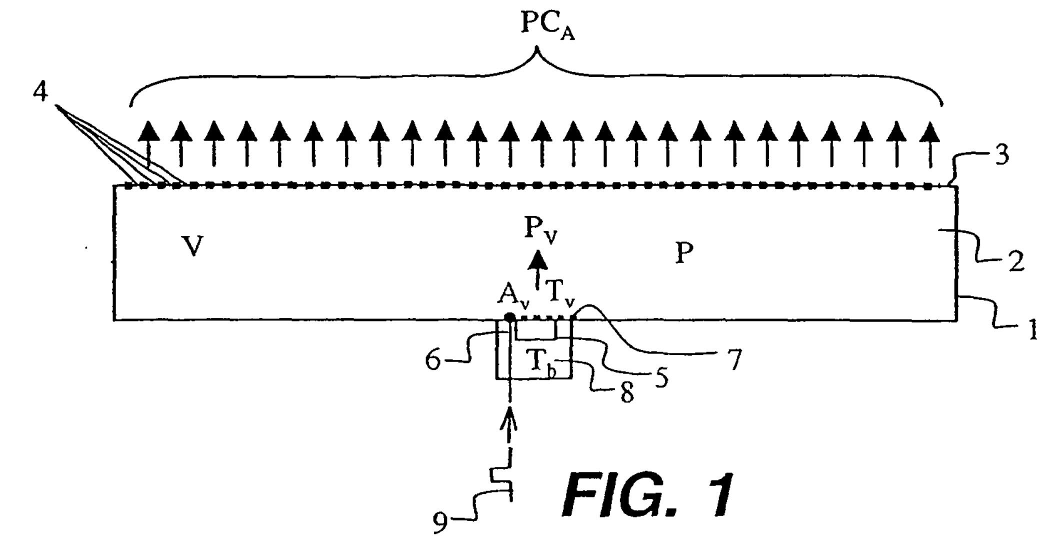
$PC_A$
4
3
V
$P_V$
P
2
$A_v$
$T_v$
1
6
$T_b$
7
5
8
9

FIG. 1

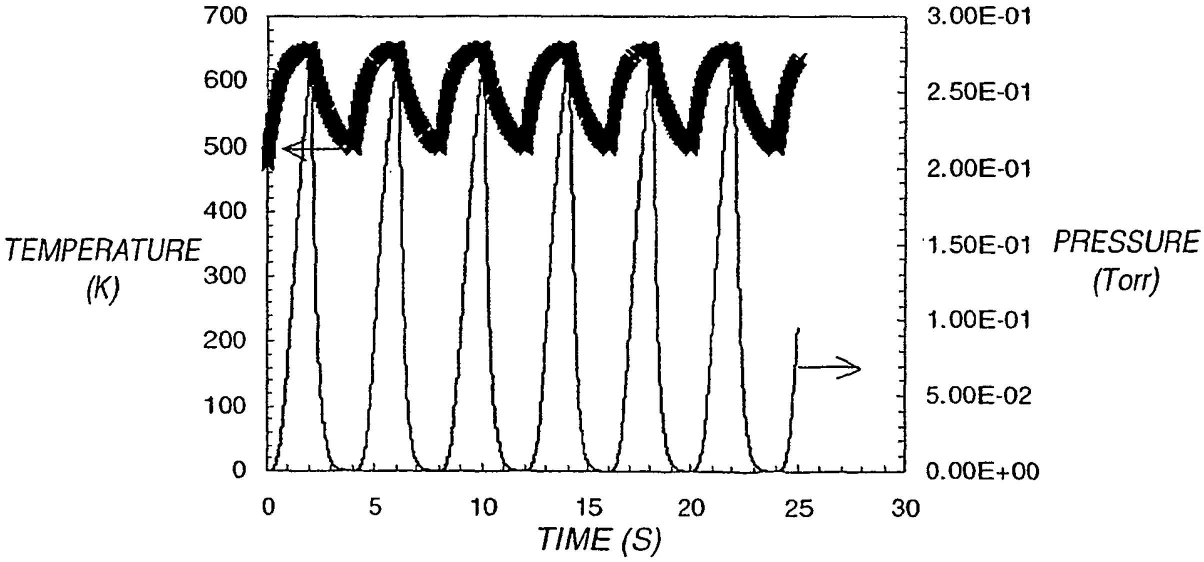
700
600
500
400
TEMPERATURE (K)
300
200
100
0
3.00E-01
2.50E-01
2.00E-01
1.50E-01
1.00E-01
5.00E-02
0.00E+00
PRESSURE (Torr)
0
5
10
15
20
25
30
TIME (S)

FIG. 2

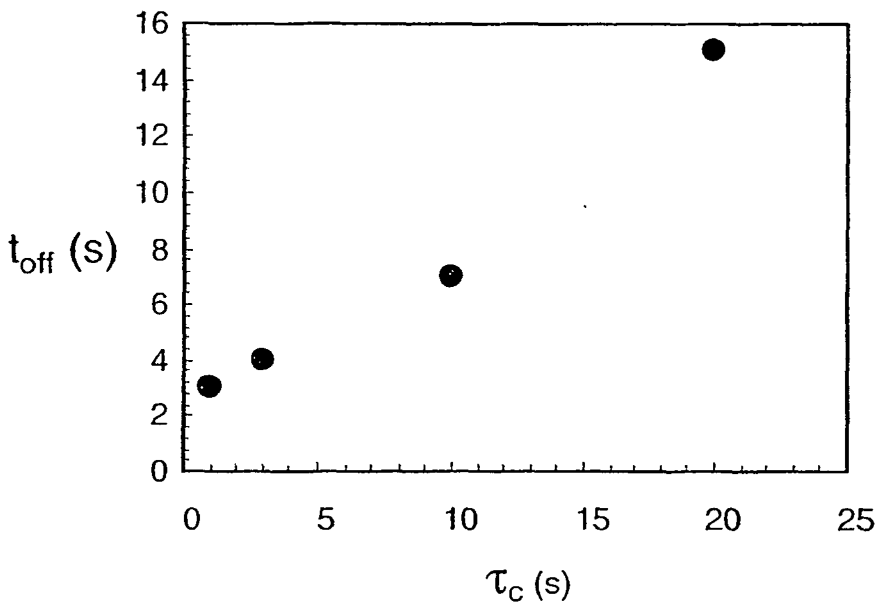


FIG. 3

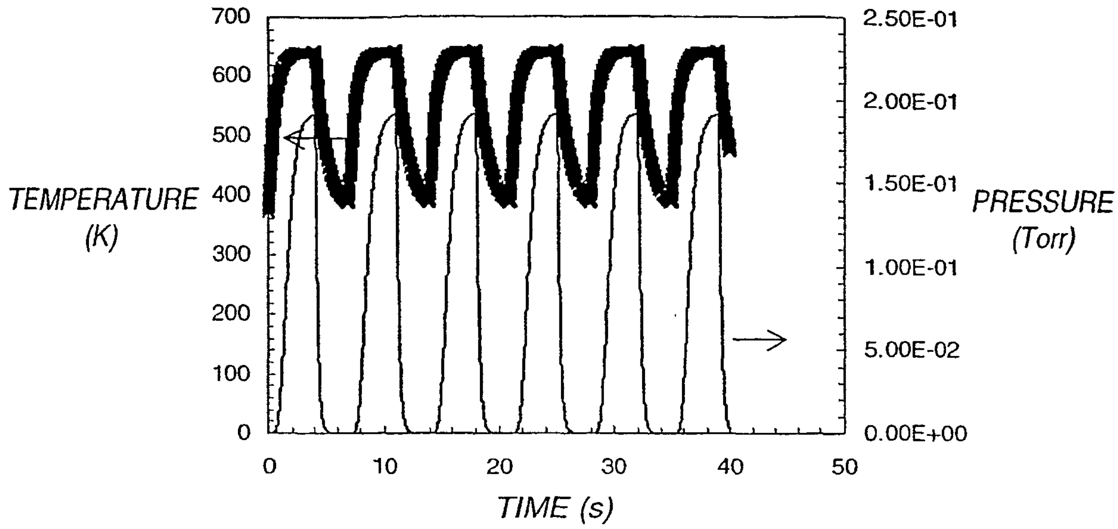
700
600
500
400
300
200
100
0
TEMPERATURE
(K)
2.50E-01
2.00E-01
1.50E-01
1.00E-01
5.00E-02
0.00E+00
PRESSURE
(Torr)
0
10
20
30
40
50
TIME (s)

FIG. 4A

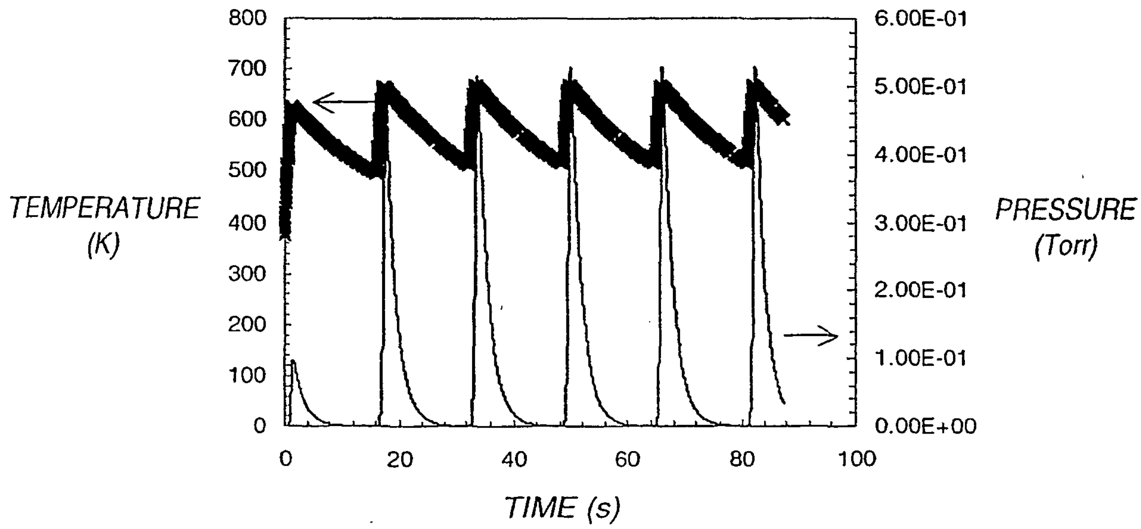
800
700
600
500
400
300
200
100
0
TEMPERATURE
(K)
6.00E-01
5.00E-01
4.00E-01
3.00E-01
2.00E-01
1.00E-01
0.00E+00
PRESSURE
(Torr)
0
20
40
60
80
100
TIME (s)

FIG. 4B

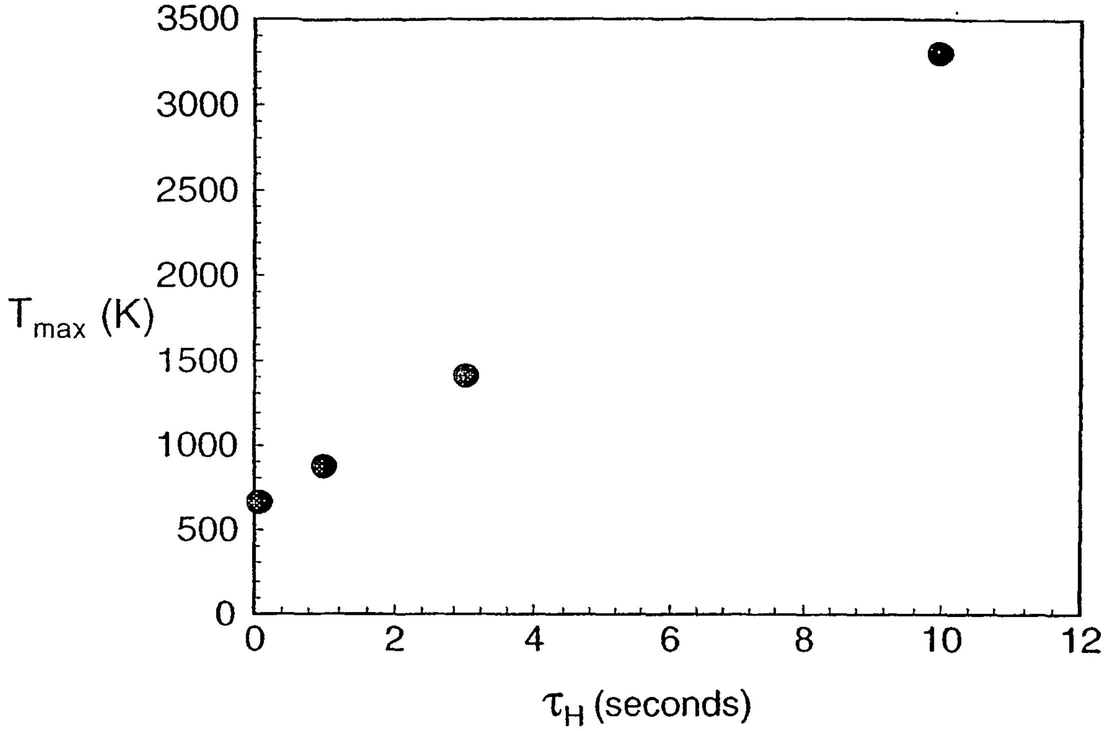
3500
3000
2500
2000
$T_{max}$ (K)
1500
1000
500
0
0
2
4
6
8
10
12
$\tau_H$ (seconds)

*FIG. 5*

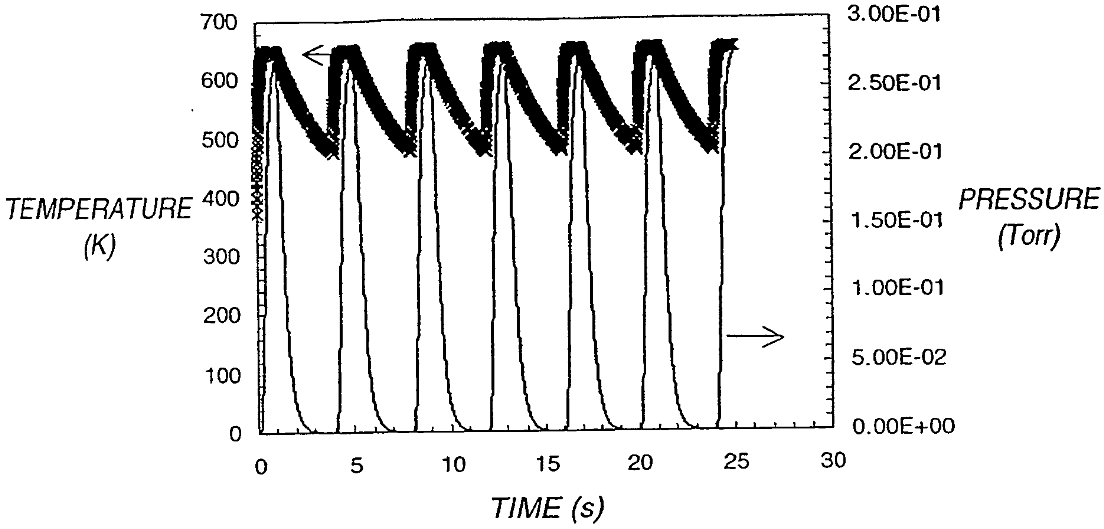

700
600
500
400
300
200
100
0
TEMPERATURE (K)
3.00E-01
2.50E-01
2.00E-01
1.50E-01
1.00E-01
5.00E-02
0.00E+00
PRESSURE (Torr)
0
5
10
15
20
25
30
TIME (s)


FIG. 6A

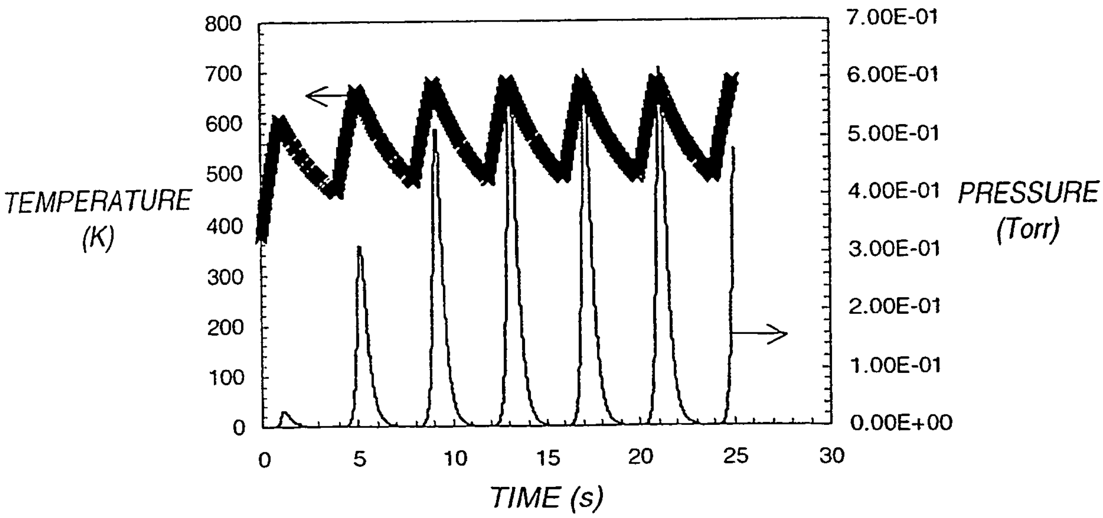

800
700
600
500
400
300
200
100
0
TEMPERATURE (K)
7.00E-01
6.00E-01
5.00E-01
4.00E-01
3.00E-01
2.00E-01
1.00E-01
0.00E+00
PRESSURE (Torr)
0
5
10
15
20
25
30
TIME (s)


FIG. 6B

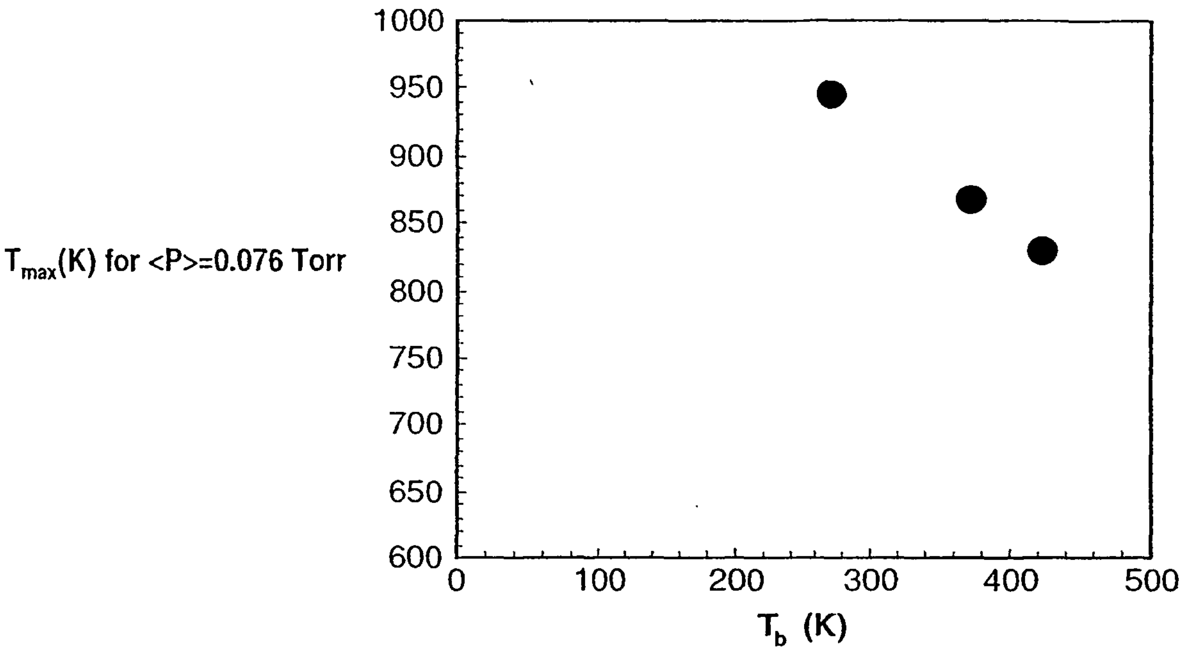
1000
950
900
850
800
750
700
650
600
Tmax(K) for <P>=0.076 Torr
0
100
200
300
400
500
Tb (K)

FIG. 7

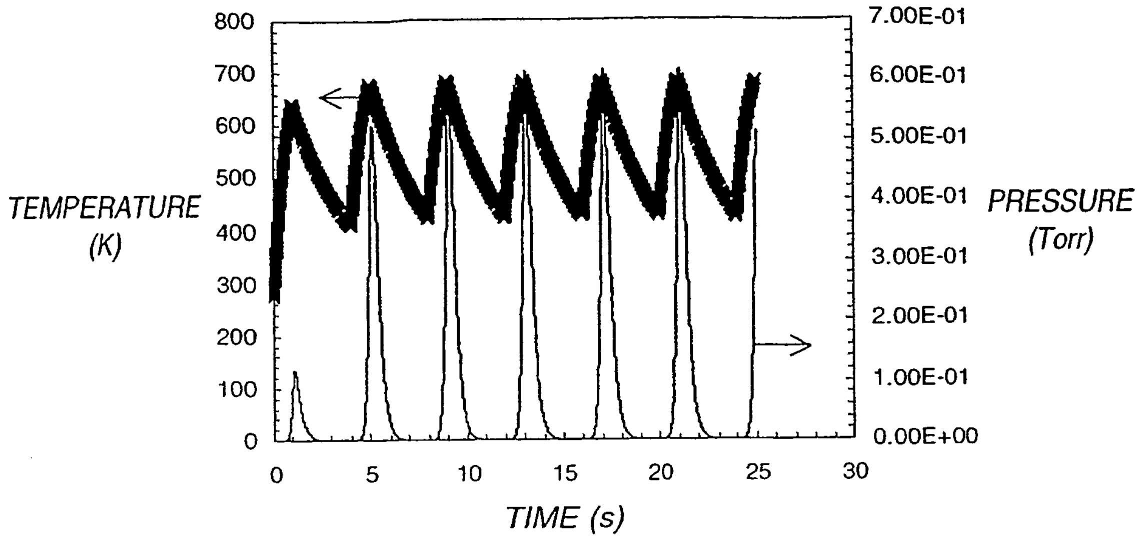
800
700
600
500
400
300
200
100
0
TEMPERATURE (K)
7.00E-01
6.00E-01
5.00E-01
4.00E-01
3.00E-01
2.00E-01
1.00E-01
0.00E+00
PRESSURE (Torr)
0
5
10
15
20
25
30
TIME (s)

*FIG. 8A*

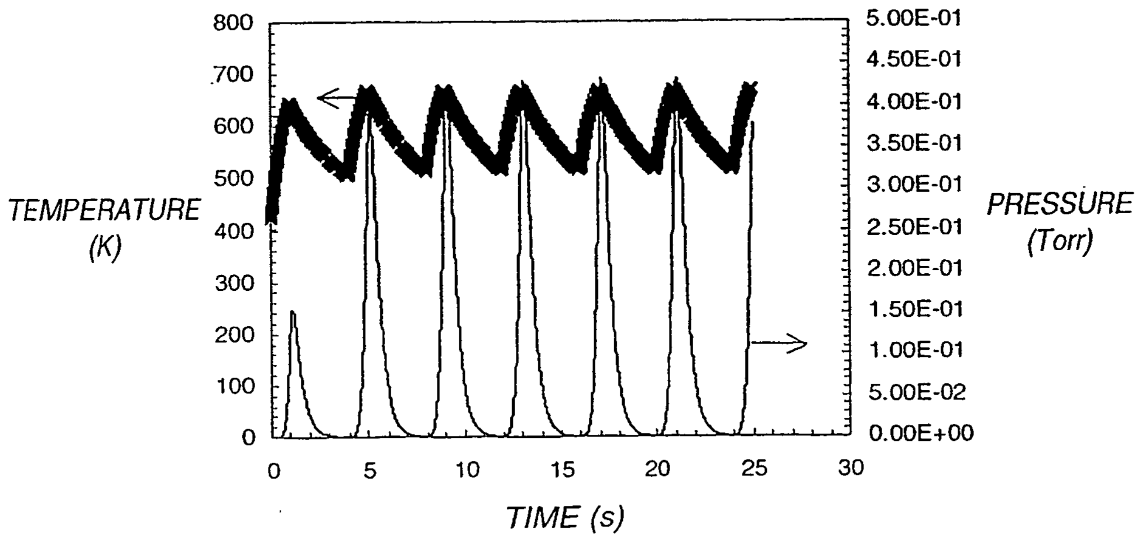
800
700
600
500
400
300
200
100
0
TEMPERATURE (K)
5.00E-01
4.50E-01
4.00E-01
3.50E-01
3.00E-01
2.50E-01
2.00E-01
1.50E-01
1.00E-01
5.00E-02
0.00E+00
PRESSURE (Torr)
0
5
10
15
20
25
30
TIME (s)

*FIG. 8B*

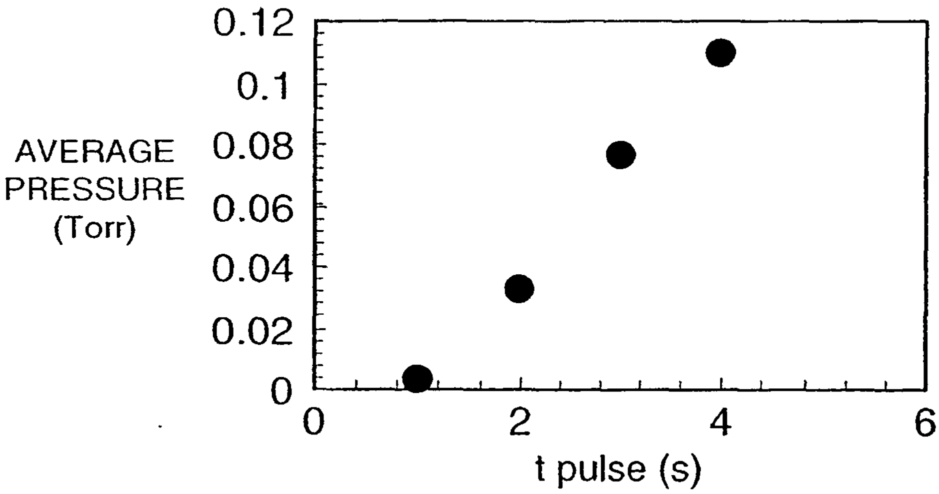


*FIG. 9*

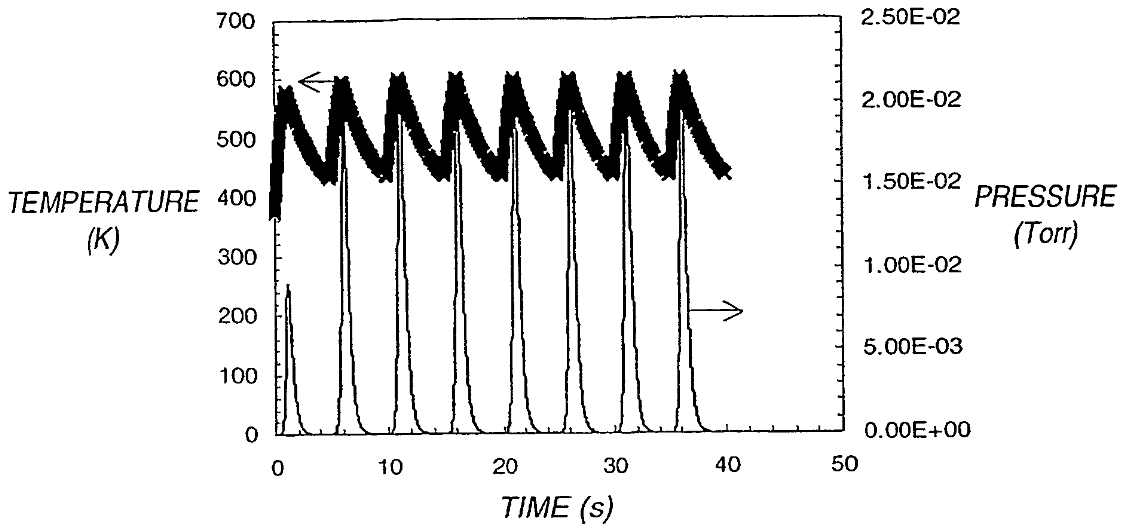


FIG. 10A

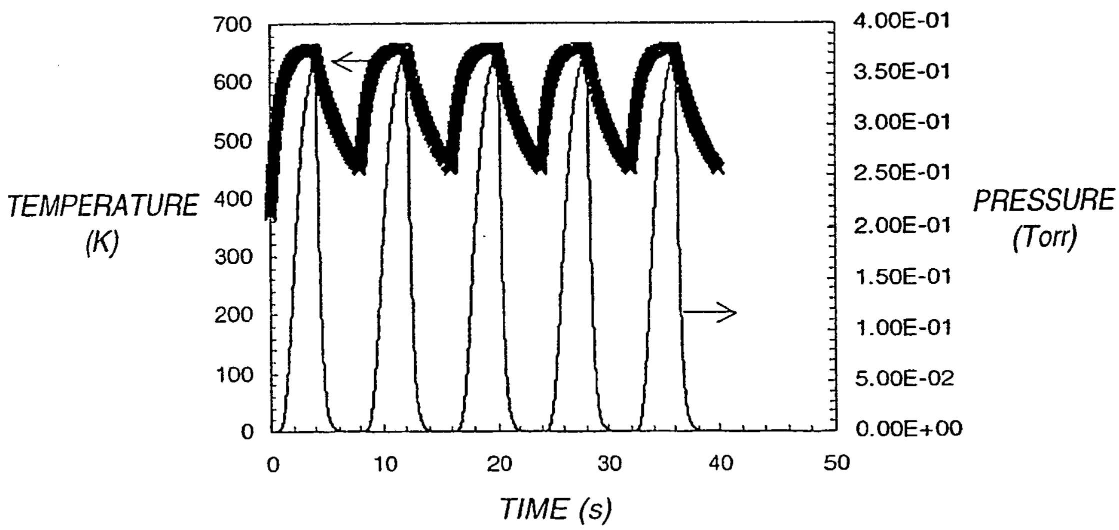


FIG. 10B

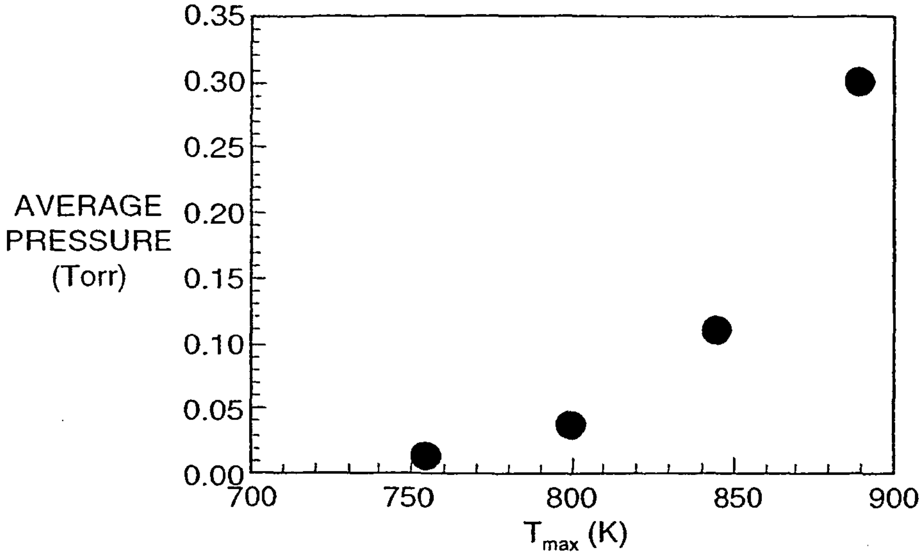
AVERAGE PRESSURE (Torr)
0.35
0.30
0.25
0.20
0.15
0.10
0.05
0.00
700
750
800
850
900
$T_{max}$ (K)

*FIG. 11*

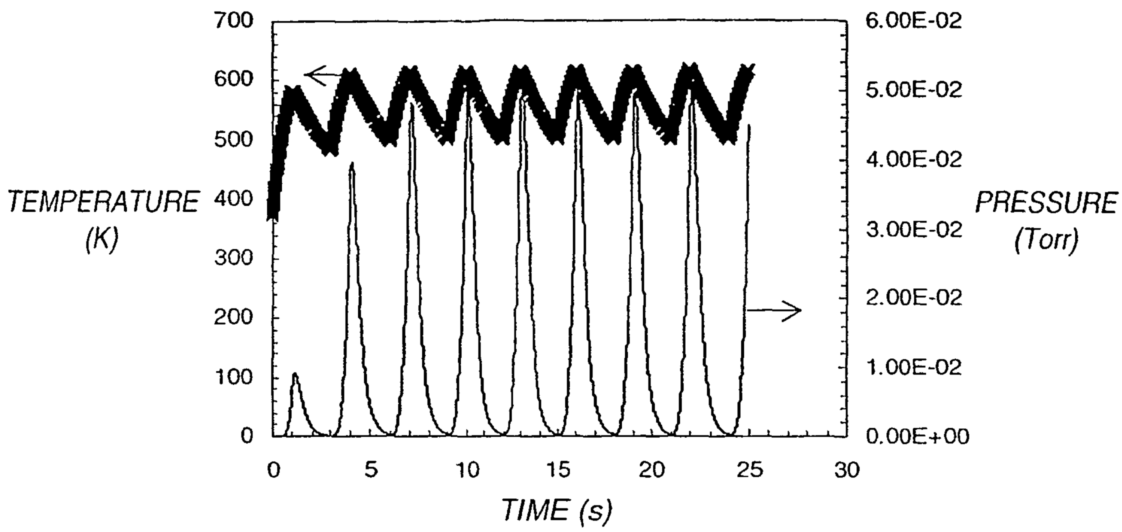


FIG. 12A

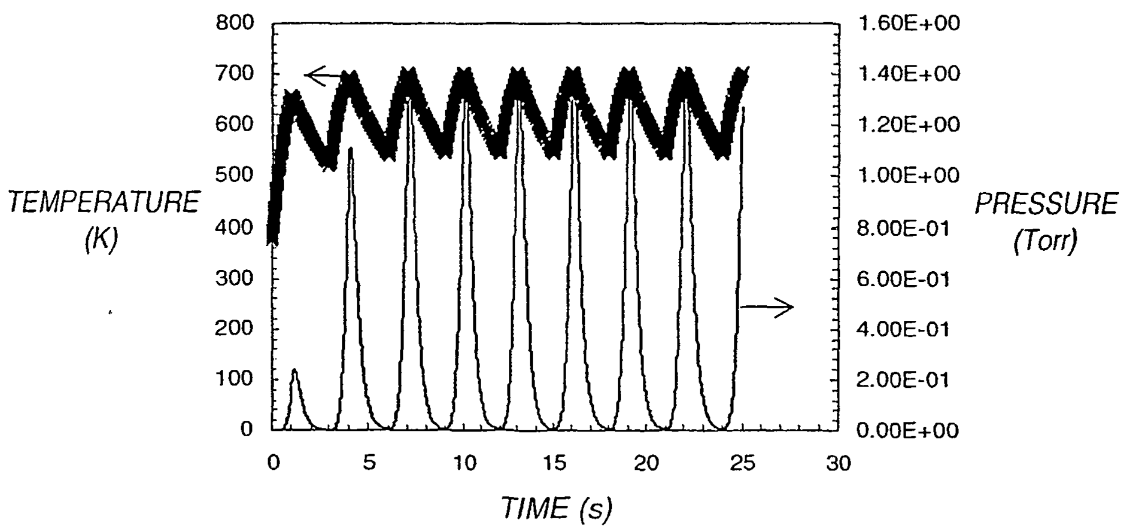


FIG. 12B

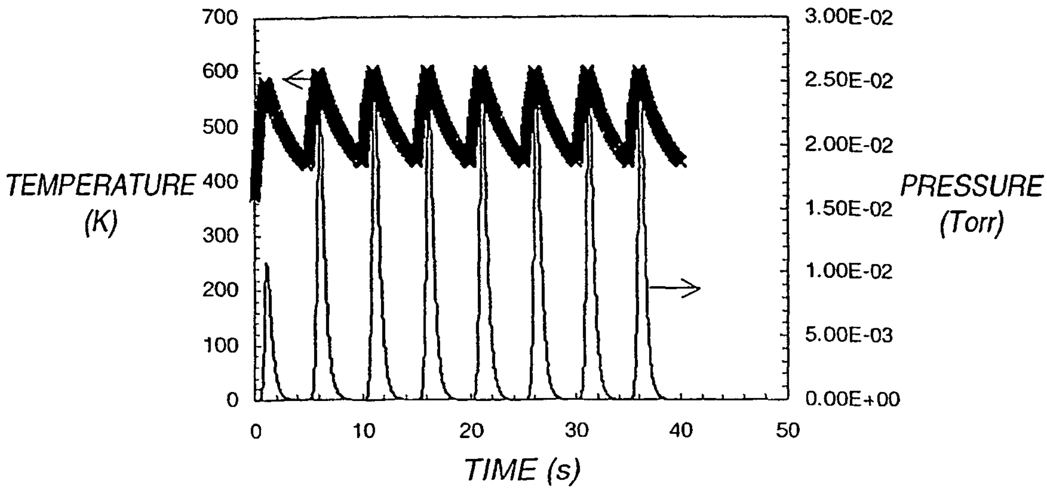


FIG. 13A

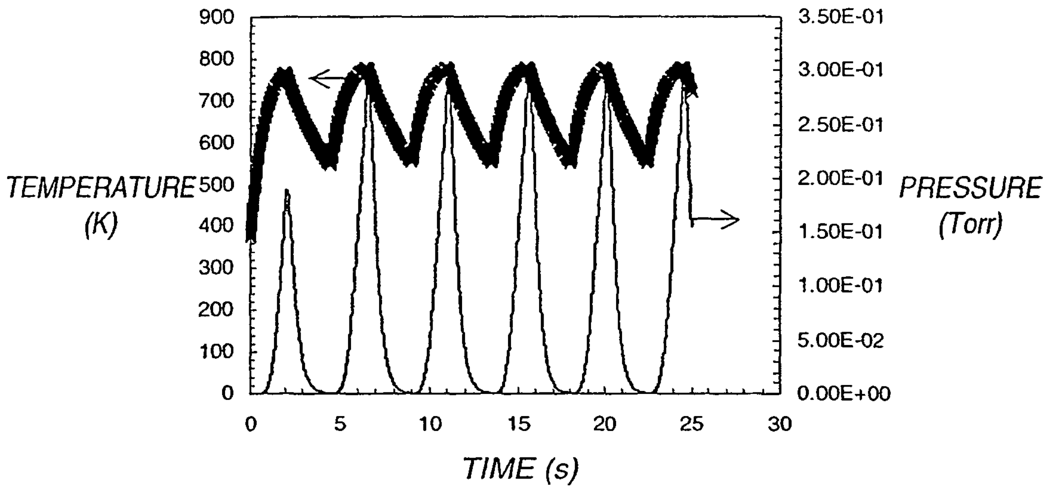


FIG. 13B

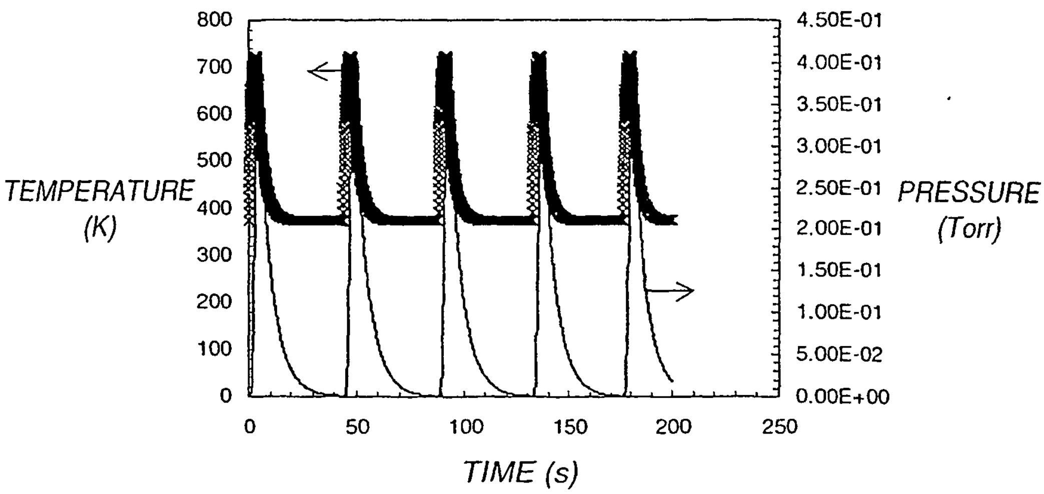


FIG. 13C

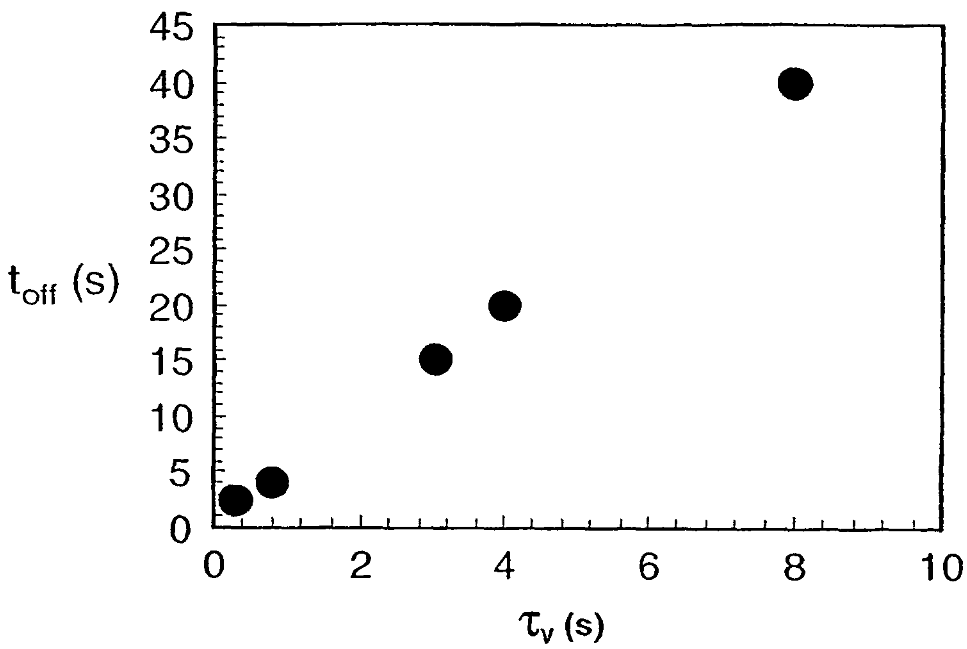


*FIG. 14*

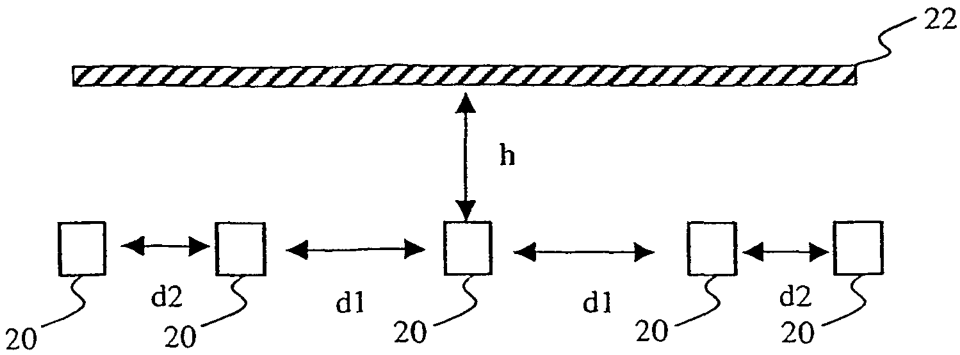


FIG. 15A

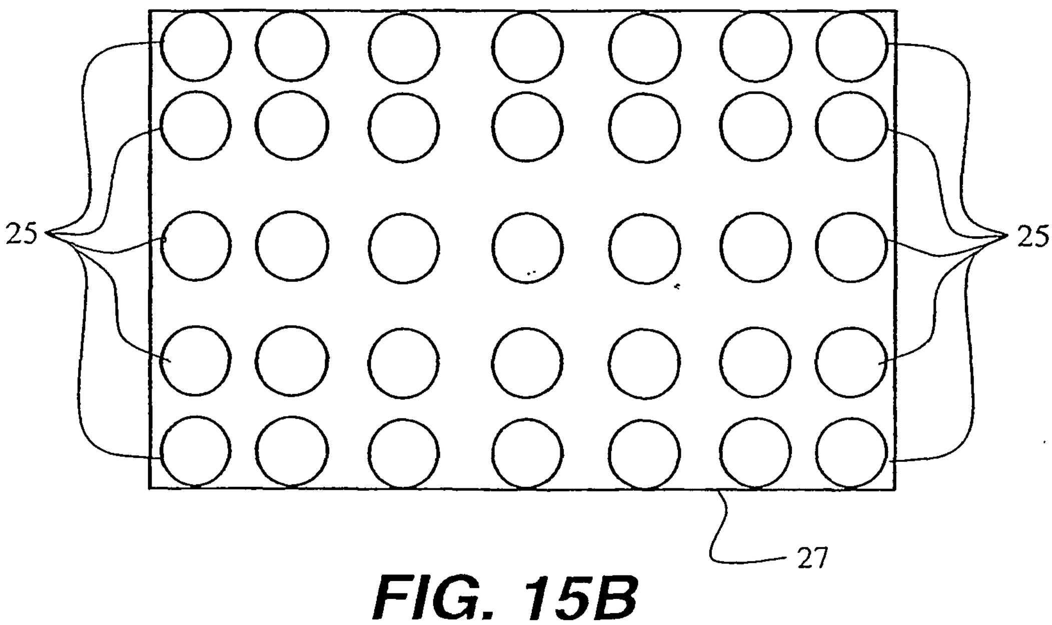


FIG. 15B

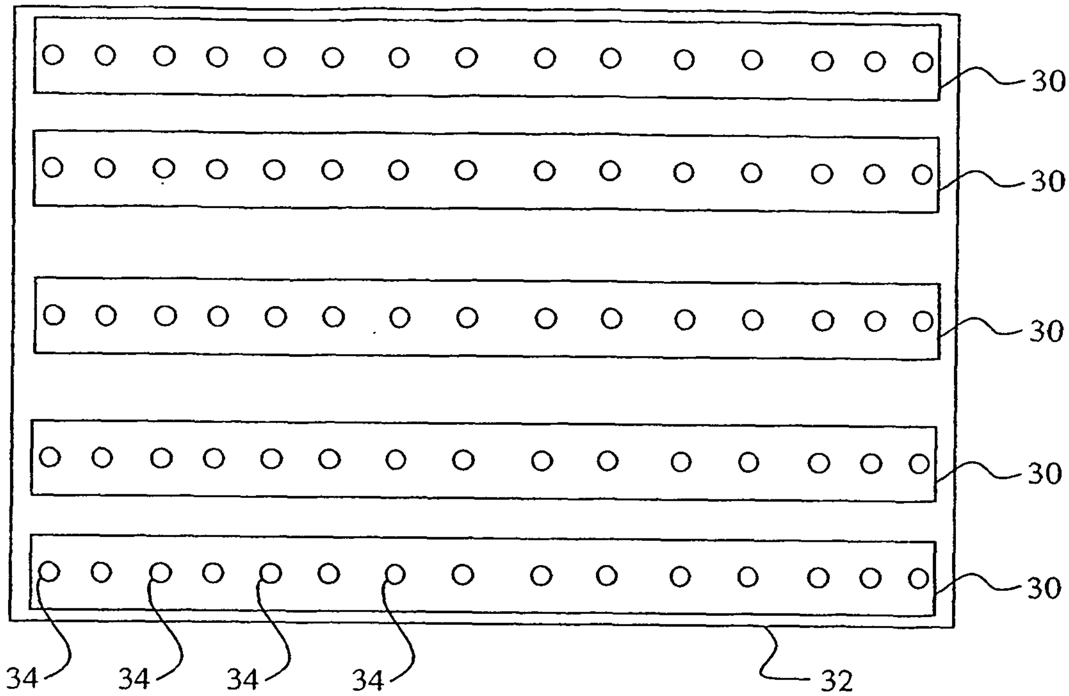


FIG. 16

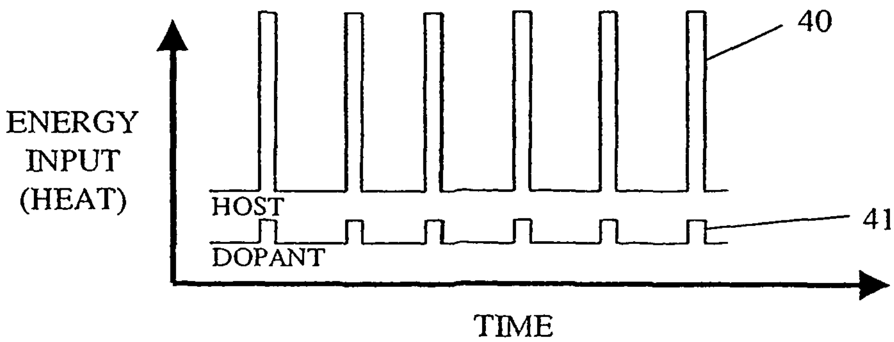


FIG. 17A

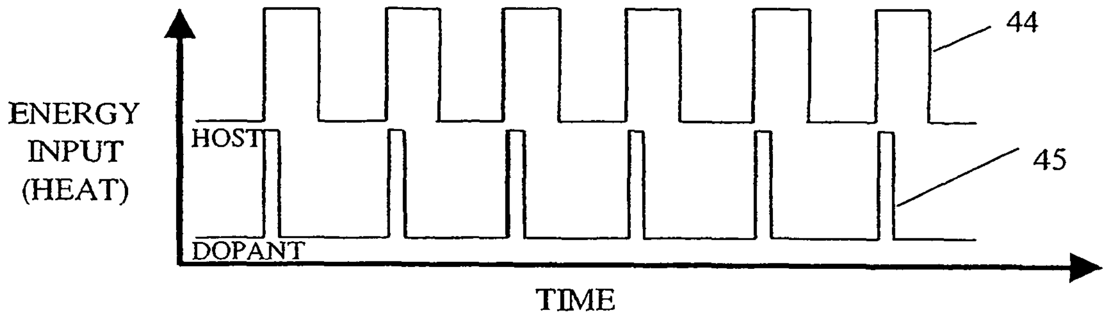


FIG. 17B

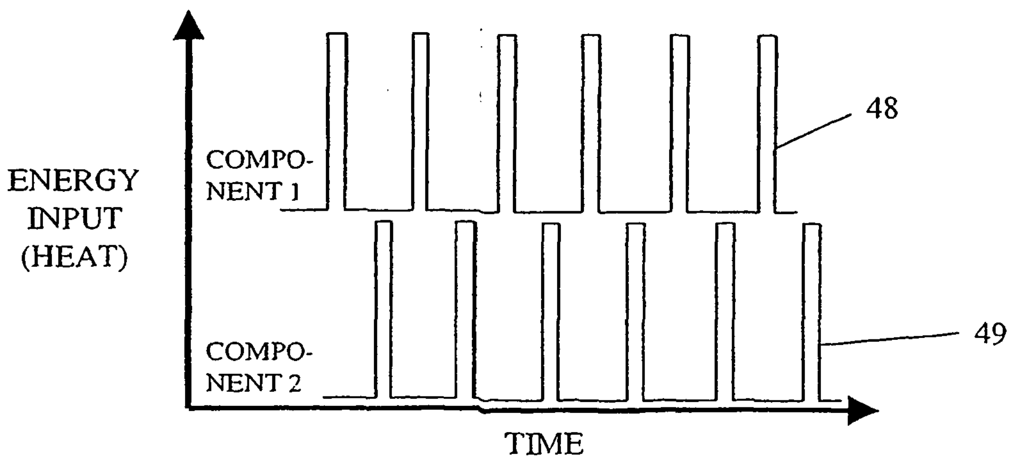


FIG. 17C

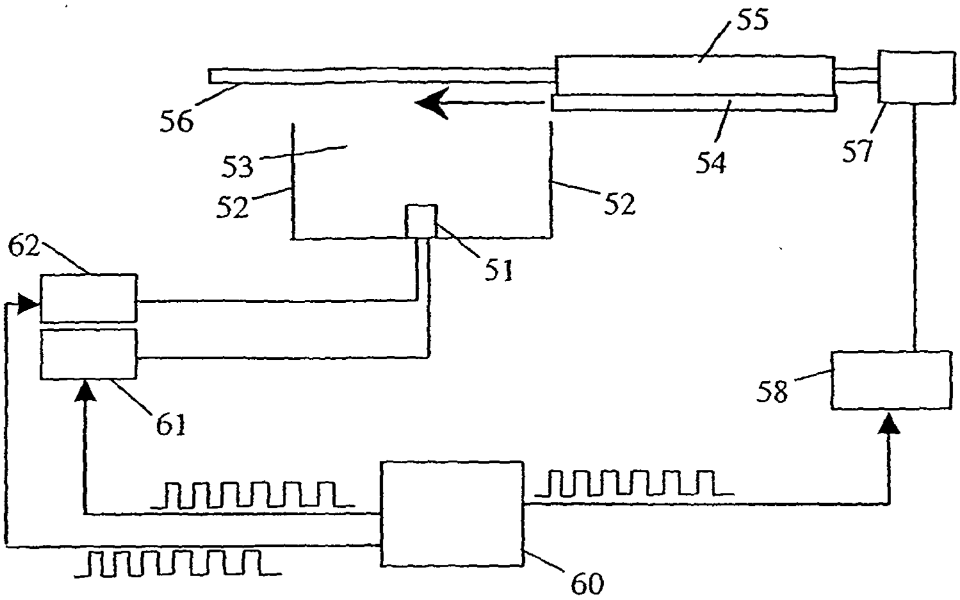
55
56
54
57
53
52
52
62
51
58
61
60

FIG. 18

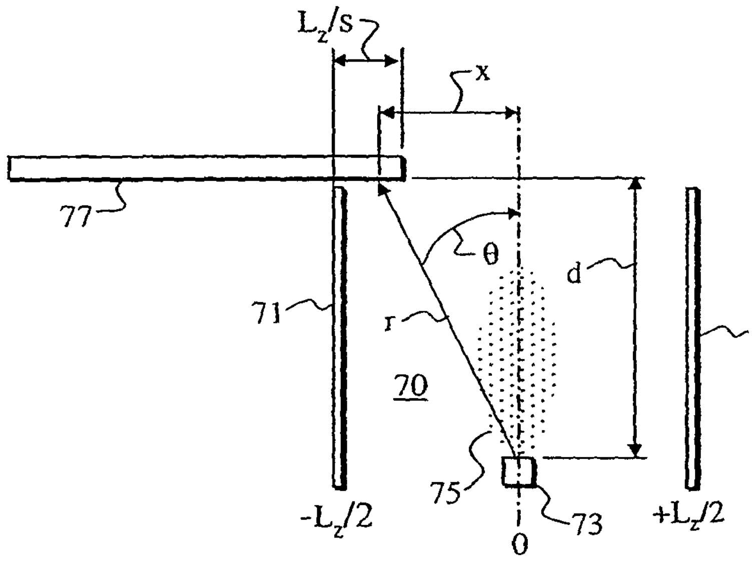
$L_z/s$
x
77
θ
d
71
r
71
70
75
73
$-L_z/2$
0
$+L_z/2$

FIG. 19

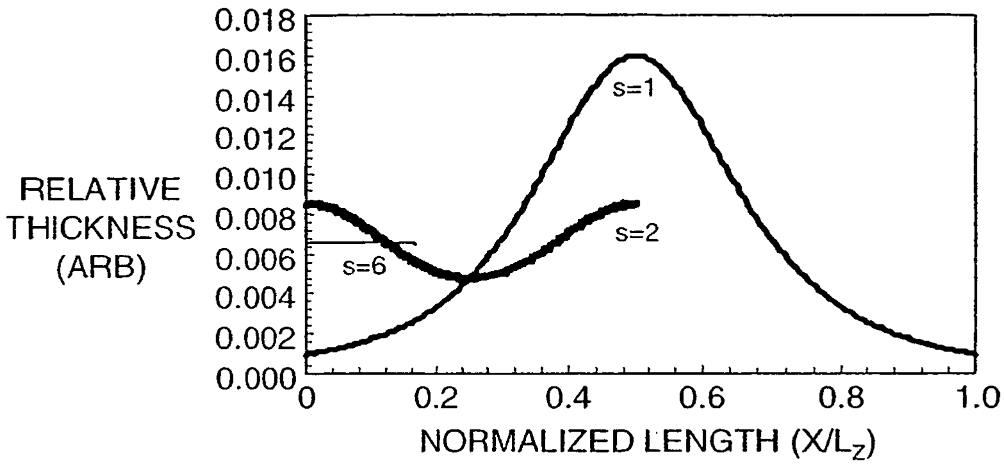
RELATIVE
THICKNESS
(ARB)
0.018
0.016
0.014
0.012
0.010
0.008
0.006
0.004
0.002
0.000
0
0.2
0.4
0.6
0.8
1.0
NORMALIZED LENGTH (X/L$_Z$)
s=1
s=2
s=6

*FIG. 20*

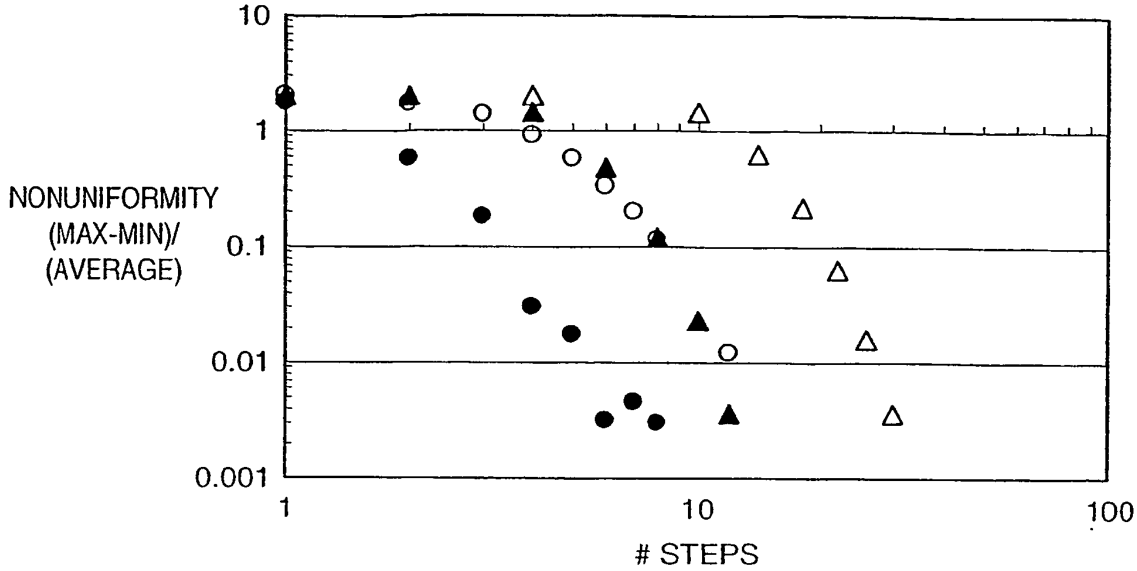
10
1
0.1
0.01
0.001
NONUNIFORMITY
(MAX-MIN)/
(AVERAGE)
1
10
100
# STEPS

*FIG. 21*

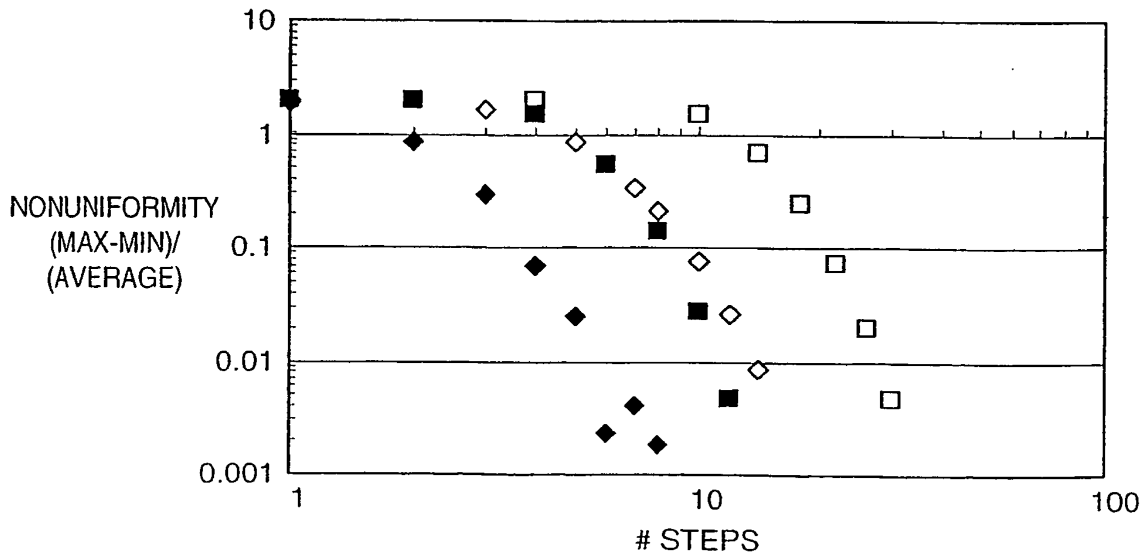
10
1
0.1
0.01
0.001
NONUNIFORMITY
(MAX-MIN)/
(AVERAGE)
1
10
100
# STEPS

*FIG. 22*

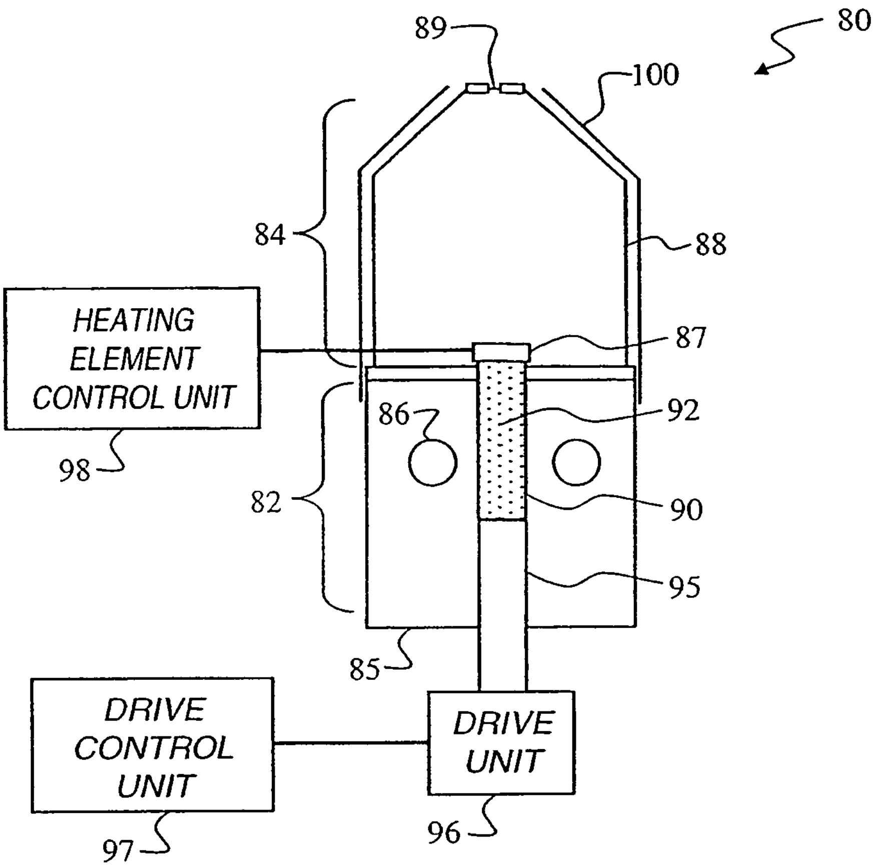
80
89
100
84
88
HEATING
ELEMENT
CONTROL UNIT
87
86
92
98
82
90
95
85
DRIVE
CONTROL
UNIT
DRIVE
UNIT
97
96

FIG. 23

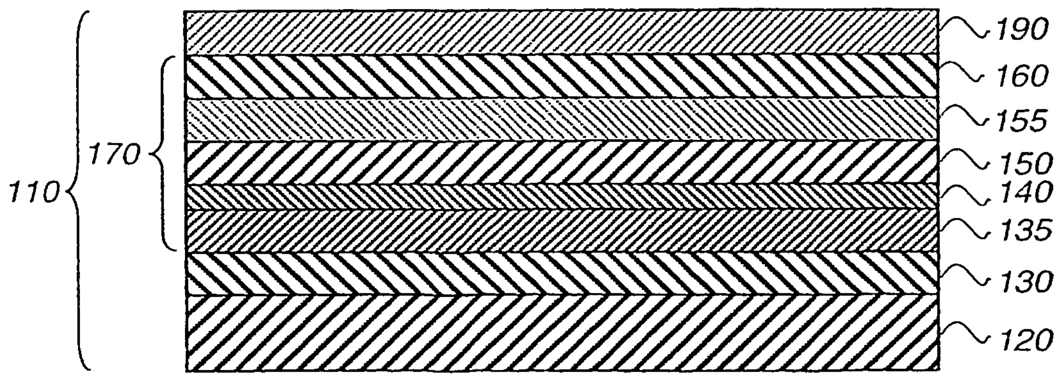
190
160
155
170
150
110
140
135
130
120

FIG. 24

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4769292 A
- US 4885211 A
- US 2447789 A, Barr
- EP 0982411 A, Tanabe
- US 3607135 A, Gereth
- US 3990894 A, Kinoshita
- JP 6161137 A, Naoyuki
- US 5453306 A, Tatsumi
- US 4226899 A, Thiel
- US 6040017 A, Mikhael
- US 6268695 B, Affinito
- JP 9219289 A, Kenji
- US 78458504 A, Michael Long
- US 784585 A
- US 35255803 A, Jeremy M. Grace
- US 4720432 A
- US 6208075 B
- EP 0891121 A1
- EP 1029909 A1
- US 3180730 A, Klupfel
- US 3567450 A, Brantley
- US 3658520 A
- US 5061569 A
- EP 1009041 A
- US 5935721 A
- WO 9855561 A
- WO 0018851 A
- WO 0057676 A
- WO 0070655 A
- US 4768292 A
- US 5141671 A
- US 5150006 A
- US 5151629 A
- US 5294870 A
- US 5405709 A
- US 5484922 A
- US 5593788 A
- US 5645948 A
- US 5683823 A
- US 5755999 A
- US 5928802 A
- US 5935720 A
- US 6020078 A
- US 6194119 B1
- US 4356429 A
- US 4539507 A
- US 4885221 A
- US 5677572 A
- US 5059861 A
- US 5059862 A
- US 6140763 A
- US 5776623 A
- US 5276380 A
- EP 0732868 A


### Non-patent literature cited in the description


- Handbook of Conductive Molecules and Polymers. John Wiley and Sons, 1997, vol. 1-4